# EUROPEAN PATENT APPLICATION

(11) **EP 4 835 495 A1**
(43) Date of publication of application: **04.11.2026**
(21) Application number: 25174124.5
(22) Date of filing: 02.05.2025
(51) Int. Cl.: G01R 15/20, G01D 5/14

(54) **CURRENT SENSOR DEVICE, SYSTEM, METHOD FOR USE IN MOTOR CONTROL OR POWER INVERTER**

(71) Applicant: Melexis Technologies SA, 2022 Bevaix (CH)
(72) Inventor: Houis, Simon, 2022 Bevaix (CH); DUPONT, Guido, 2022 Bevaix (CH)
(74) Representative: Jacobs, Lambert

(57) **Abstract**

A sensor system (101; 201; 301) comprising: a plurality of electrical conductor portions (A, B, C) spaced apart from each other, for conducting a plurality of electrical currents, that will generate respective magnetic fields, together forming a combined magnetic field; a first sensor device (104; 204; 304) comprising a plurality of magnetic sensor elements for measuring the combined magnetic field; wherein the first sensor device is configured to measure at least two magnetic field components (Bx,By) or differences (ΔBx, ΔBy); and to determine and/or output at least one of the following: a) signals indicative of (e.g. proportional to) the electrical currents flowing through the conductor portions; b) signals indicative of (e.g. proportional to) a field vector (v1) of the combined magnetic field, which is related to the magnetic field seen by the rotor of a motor which is powered by the same currents. A motor control system. A method of controlling a motor. A sensor device.

## Description

### Field of the invention

The present invention relates to the general field of current sensing. More specifically, the present invention relates to current sensor devices, systems and methods for example for metering, and to motor control systems and methods, for example Field-Oriented-Control (FOC) motor control systems, also known as Vector Control. The present invention can be used in electrical vehicles, but also in electrical power meters and electrical power inverters.

### Background of the invention

Current sensor systems are known in the art. It is known that a current flowing through a conductor can be determined by measuring the magnetic field generated by that current.

Electrical power meters and electrical power inverters are known in the art.

Motor control systems are known in the art. They typically comprise many components, such as e.g. a speed sensor, a speed controller, a torque controller, a modulator (e.g. a PWM modulator), a three-phase invertor comprising a plurality of dual-H bridges, a gate-driver for driving input gates of the three-phase invertor, current sensors for measuring currents flowing in the windings of the motor, an angular position sensor for measuring a position of the rotor, etc.

Vector control, also called field-oriented control (FOC), is a variable-frequency drive (VFD) control method in which stator currents of a three-phase AC motor are identified as two orthogonal components that can be visualized with a vector. One component defines the magnetic flux of the motor, the other the torque. The control system of the drive calculates the corresponding current component references from the flux and torque references given by the drive's speed control. Typically proportional-integral (PI) controllers are used to keep the measured current components at their reference values. The pulse-width modulation of the variable-frequency drive defines the transistor switching according to the stator voltage references that are the output of the PI current controllers.

Coordinate transformations like the Clarke transform and the Park transform are commonly used in field-oriented control of three-phase AC machines. The Clarke transform converts the time domain components of a three-phase system (in abc frame) to two components in an orthogonal stationary frame (αβ frame). The Park transform converts the two components in the αβ frame to an orthogonal rotating reference frame (dq frame). Implementing the Park and Clarke transforms in a consecutive manner simplifies computations by converting AC current and voltage waveform into DC signals.

There is always room for improvements or alternatives.

### Summary of the invention

It is an object of the present invention to provide a current sensor device, and a current sensor system, and a method of measuring currents, as may be used e.g. in electrical power meters or electrical power inverters.

It is also an object of the present invention to provide a current sensor device and a current sensor system, and a method of measuring currents, as may be used in motor control systems, e.g. in field-oriented (FOC) motor control systems, e.g. for electrical vehicles.

It is also an object of the present invention to provide sensor devices for use in such a sensor system, and to methods performed by such a sensor system or such sensor devices.

It is an object of embodiments of the present invention to provide a sensor system having a lower component count than existing sensor systems, and/or a sensor system that is more compact than existing sensor systems, (e.g. by not requiring a magnetic shielding), and/or a sensor system that is easier to mount (e.g. where mechanical mounting tolerances are relaxed), and/or a sensor system with an improved reliability (e.g. improved error detection capabilities), and/or a sensor system with an improved accuracy, and/or a sensor system that provides signals with less noise or spikes, and/or a sensor system that is less sensitive to external influences, and preferably two or more of these.

These and other objectives are accomplished by embodiments of the present invention.

According to a first aspect, the present invention provides a sensor system comprising: a plurality of (e.g. two or three or more than three) electrical conductor portions (e.g. A, B, C) spaced apart from each other, and configured for conducting a plurality of electrical currents (e.g. la, Ib, Ic) of a multiphase (or polyphase) current system, wherein each current will generate a respective magnetic field, which magnetic fields are superimposed to form a combined magnetic field; a first sensor device comprising a plurality of magnetic sensors (or a plurality of magnetic sensor elements), configured for measuring characteristics of the combined magnetic field; wherein the first sensor device is configured to measure at least two magnetic field components or at least two magnetic field differences or at least two magnetic field gradients of the combined magnetic field in one or more sensor locations; and wherein the sensor system is configured to perform at least one of the following: a) to output one or more of the measured magnetic field components or magnetic field differences or magnetic field gradients; b) calculate and/or output two or more signals (e.g. Ia,Ib,Ic; Iα,Iβ, |I|) indicative of (e.g. proportional to) the electrical currents (e.g. la, Ib, Ic) flowing in said electrical conductor portions; c) calculate and/or output one or more signals (e.g. Bx,By; |B|,ϕ) indicative of (e.g. proportional to) a field vector of the combined magnetic field generated by the currents flowing through the electrical conductor portions (which may be a mirror, or a transformation or remapping of the vector of the magnetic field induced by the same currents flowing in the motor coils), and/or one or more signals (e.g. dB/dt; dϕ/dt; Δϕ; Id,lq) derived therefrom, based (at least) on said at least two magnetic field components or said at least two magnetic field differences or said at least two magnetic field gradients.

It is a major advantage that the combined magnetic field (generated by e.g. three currents) can be measured using a single sensor device (instead of requiring three current sensor devices).

Experiments have surprisingly shown that current values derived from measurements of the combined or superimposed magnetic field, and thus also values derived therefrom, are very "clean" signals without a lot of noise or spikes. Such "clean" signals are highly suited for motor control, more than e.g. current sensor signals measured by a plurality of discrete sensor devices.

This sensor system may be part of a motor control system (see second aspect).

The two magnetic field differences can be obtained from a first pair of magnetic field components oriented in a first direction (e.g. X) and a second pair of magnetic field components oriented in a second direction (e.g. Y), as can be provided e.g. by two 2D magnetic sensors.

Alternatively, the two magnetic field differences can be obtained from three magnetic field components (e.g. Bx1, Bx2, Bx3) oriented in the same direction, but measured at three different locations, as can be provided e.g. by three 1D magnetic sensors.

Step b) may comprise the use of the Clark transform.

It is noted that the sensor device can output many different values or signals. In some embodiments without a motor (e.g. an electrical power meter, or a power convertor) the values which are output are related to the combined magnetic field generated by the currents flowing through the electrical conductor portions, but not flowing in a motor.

In other embodiments, where the sensors system is connected to a motor, the values which are output can either be the "raw" magnetic field components, differences, norm, angle, etc. of the magnetic field measured in the vicinity of the conductor portions (in which case other circuitry may convert them into values related to currents and/or the magnetic field inside the motor); or the values which are output are already translated into currents and/or magnetic field values inside the motor. Both options are possible.

It is noted that the angle ϕ derived from the magnetic field generated by the currents la, Ib, Ic flowing through the electrical conductor portions corresponds to the "electrical angle" of the currents flowing through the motor, which may correspond to the physical angle of the motor scaled with an integer value M.

In an embodiment, the sensor system is configured to output at least |B| and ϕ.

In another or further embodiment, the sensor system is configured to output at least la, Ib, Ic. In another or further embodiment, the sensor system is configured to output at least Iα, Iβ.

In preferred embodiments, the first sensor device comprises only a single semiconductor substrate.

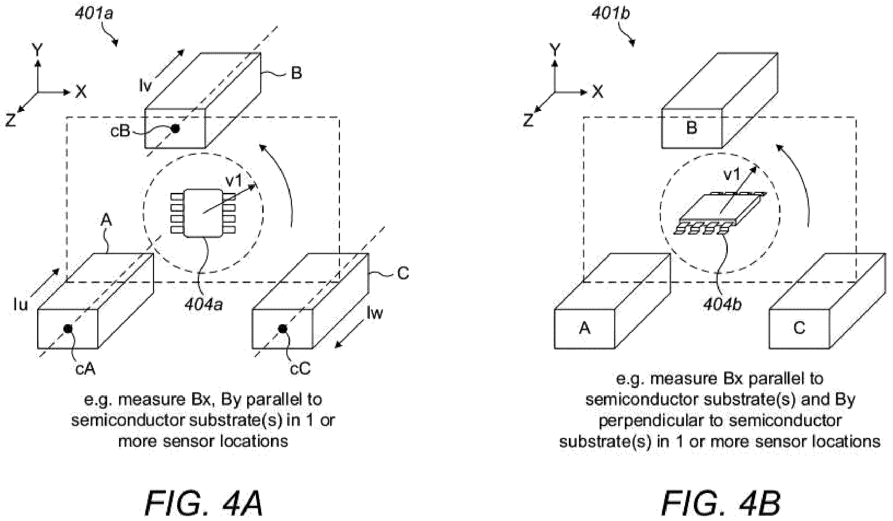

In some embodiments, the first sensor device may comprise magnetic sensor structures with an integrated magnetic field concentrator IMC, for example an IMC and at least two horizontal Hall elements arranged near a periphery of the IMC and angularly spaced by 180°; or an IMC and at least four horizontal Hall elements arranged near a periphery of the IMC and angularly spaced by multiples of 90°. It is an advantage that this sensor device can be mounted on a printed circuit board that is oriented parallel to the electrical conductor portions (see e.g. FIG. 4B, FIG. 9, FIG. 10). Such arrangement may be more compact than an arrangement where the semiconductor substrate is oriented perpendicular to the electrical conductor portions (e.g. as illustrated in FIG. 4A).

In some embodiments, the first sensor device does not comprise an integrated magnetic flux concentrator, but comprises e.g. horizontal Hall elements and/or vertical Hall elements and/or magneto-resistive (MR) elements (e.g. GMR, XMR, TMR elements).

In an embodiment, the sensor system comprises three conductor portions, and the first sensor device is configured to output three values (la, Ib, Ic) proportional to the currents flowing through the conductor portions. In another or a further embodiment, the first sensor device is configured to output values two values (Iα, Iβ) proportional to orthogonal projections of these three currents. In another or a further embodiment, the first sensor device is configured to output a value indicative of (e.g. proportional to) the norm (e.g. |B|) of the magnetic field and an angle (e.g. ϕ) of the magnetic field generated by currents flowing through the conductor portions.

In an embodiment, the sensor system further comprises a second sensor device communicatively connected to the first sensor device, the second sensor device being configured for determining an actual angular position (e.g. ϕrot); and one or both of the following options: i) wherein the first sensor device is configured for receiving said actual angular position (e.g. ϕrot) from the second sensor device, and for determining an angular difference (e.g. Δϕ) between an angle (e.g. ϕ) of said vector (e.g. v1) of the combined magnetic field and the actual angular position (e.g. ϕrot), and for optionally outputting this angular difference (e.g. Δϕ); ii) wherein the second sensor device is configured for receiving one or more of said signals (e.g. la,lb,lc, Iα,Iβ, |I|, Bx,By, ΔBx, ΔBy, |B|,ϕ, dB/dt, dϕ/dt) from the first sensor device, and is further configured for determining an angular difference (e.g. Δϕ) between an angle (e.g. ϕ) of said combined magnetic field and an angle related to the actual angular position (e.g. ϕrot), and for optionally outputting at least this angular difference (e.g. Δϕ).

The angular difference may be calculated for example as Δϕ= (ϕ- ϕrot) or as Δϕ= (ϕ-ϕrot/M) or as Δϕ= (ϕ-ϕrot*M), where M is an integer value, dependent on the motor.

In this embodiment, a processor or processing circuit external from the first and second sensor device, may be configured to receive the actual angular position (ϕrot) and the angular difference (Δϕ) from the first and second sensor device, and may be further configured to perform a Park transform to convert the angular difference (Δϕ) into a set of currents (Id, Iq) values in a rotor-reference-frame (typically referred to as the DQ reference frame).

In an embodiment or a further embodiment, the sensor system is configured to output at least Δϕ.

In an embodiment (e.g. in an inverter application), the actual angular position ϕrot may be the phase of a (rotating or sinusoidal) voltage signal.

In an embodiment, one of the first sensor device and the second sensor device is further configured to convert the angular difference (e.g. Δϕ) into a set of currents (e.g. Id, Iq) in a rotor-reference-frame (also referred to as "dq-reference frame), and to output these current values.

The "rotor reference frame" is an imaginary coordinate system fixedly connected to the rotor.

In an embodiment or further embodiment, the sensor system is configured to output at least Id,lq.

In an embodiment, the first sensor device comprises at least two magnetic sensors (e.g. S1, S2) spaced apart from each other, each magnetic sensor configured for measuring at least two magnetic field components oriented in two different directions, e.g. two orthogonal magnetic field components (e.g. Bx1,By1; Bx2,By2); and the first sensor device is configured for determining at least two magnetic field differences (e.g. ΔBx; ΔBy) or at least two magnetic field gradients based on pairwise differences of said magnetic field components, or based on a difference between a measured magnetic field component (e.g. Bx) and an average component (e.g. Bx_avg); and the first sensor device is configured to determine and optionally output said one or more signals (e.g. la,lb,lc, Iα,Iβ, |I|, Bx,By, ΔBx, ΔBy, |B|,ϕ, dB/dt, dϕ/dt, Id, Iq) based on said at least two magnetic field differences or based on said at least two magnetic field gradients.

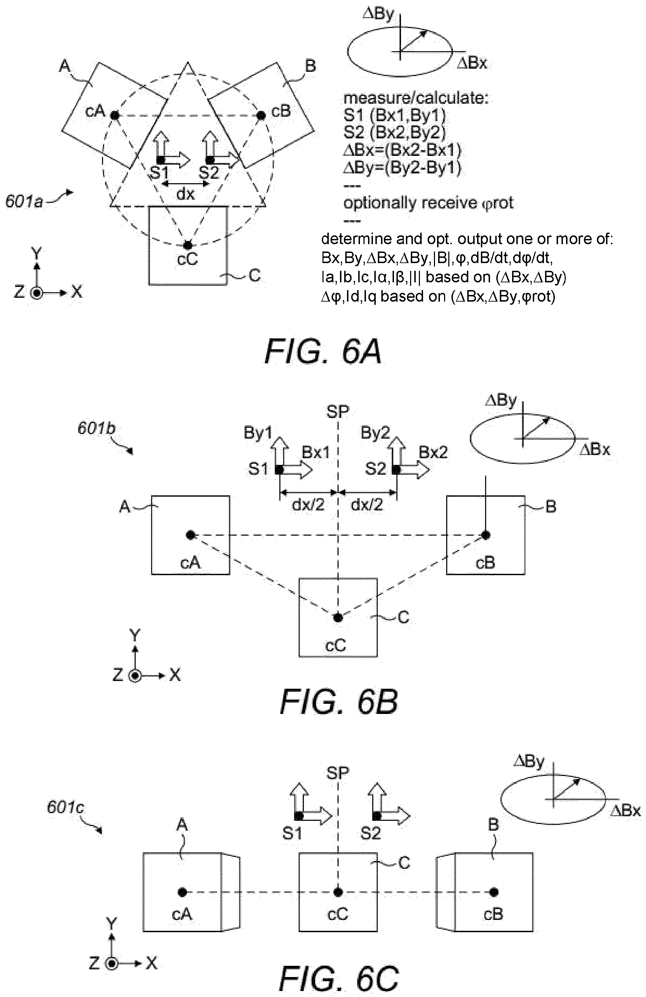

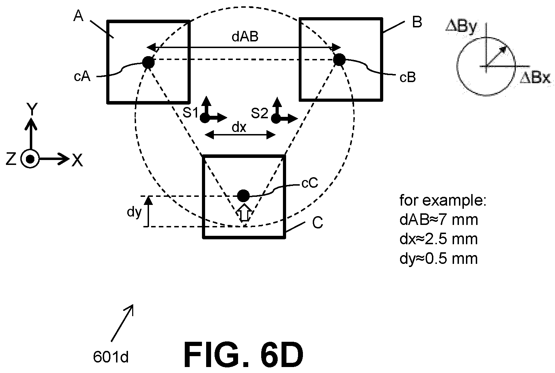

Examples of this embodiment are shown in FIG. 6, FIG. 7, and FIG. 10.

In an embodiment, the first sensor device comprises at least three magnetic sensors (e.g. S1, S2, S3) spaced apart from each other, each magnetic sensor configured for measuring at least one magnetic field component (e.g. Bx1,Bx2,Bx3) oriented in a predefined direction (e.g. X); and wherein the first sensor device is configured for determining at least two magnetic field differences (e.g. ΔBx12,ΔBx23) or at least two magnetic field gradients based on pairwise differences of said magnetic field components, or based on a difference between a measured magnetic field component and an average component; and wherein the first sensor device is configured to determine and optionally output said one or more signals (e.g. la,lb,lc, Iα,Iβ, |I|, ΔBx12, ΔBx23, |B|,ϕ, dB/dt, dϕ/dt, Id, Iq) based on said at least two magnetic field differences or based on said at least two magnetic field gradients.

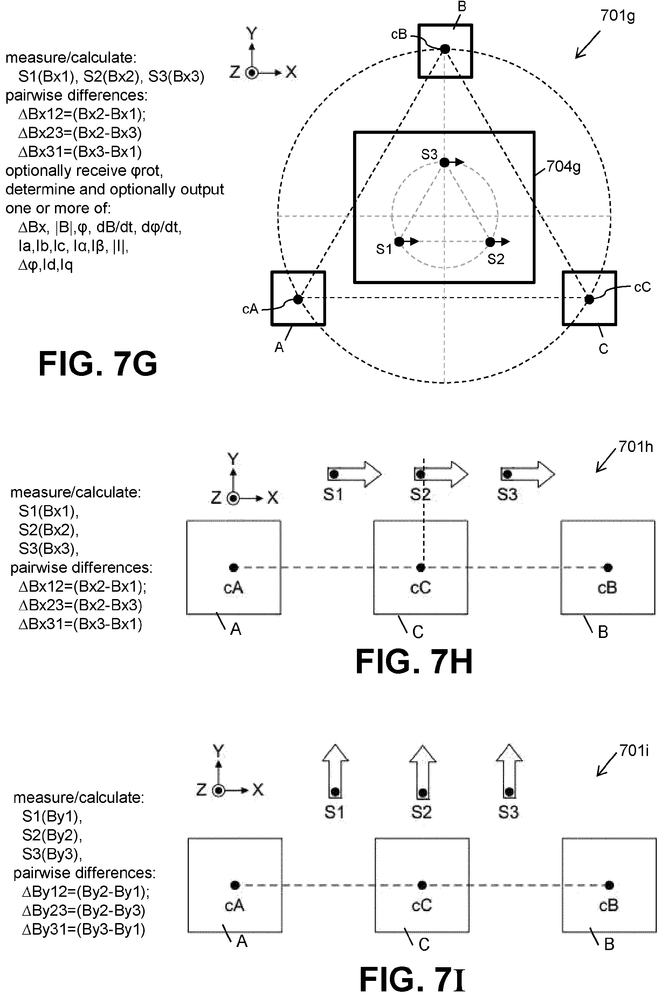

Examples of this embodiment are shown in FIG. 7G to FIG. 7K.

In an embodiment, the first sensor device comprises at least one magnetic sensor configured for measuring at least two (or only two) orthogonal magnetic field components at a predefined location; and the first sensor device is configured to determine and optionally output said one or more signals (e.g. Ia,Ib,Ic, Iα,Iβ, [I], Bx,By, ΔBx, ΔBy, |B|,ϕ, dB/dt, dϕ/dt, Id, Iq) based on said at least two orthogonal magnetic field components, optionally taking into account said angular position.

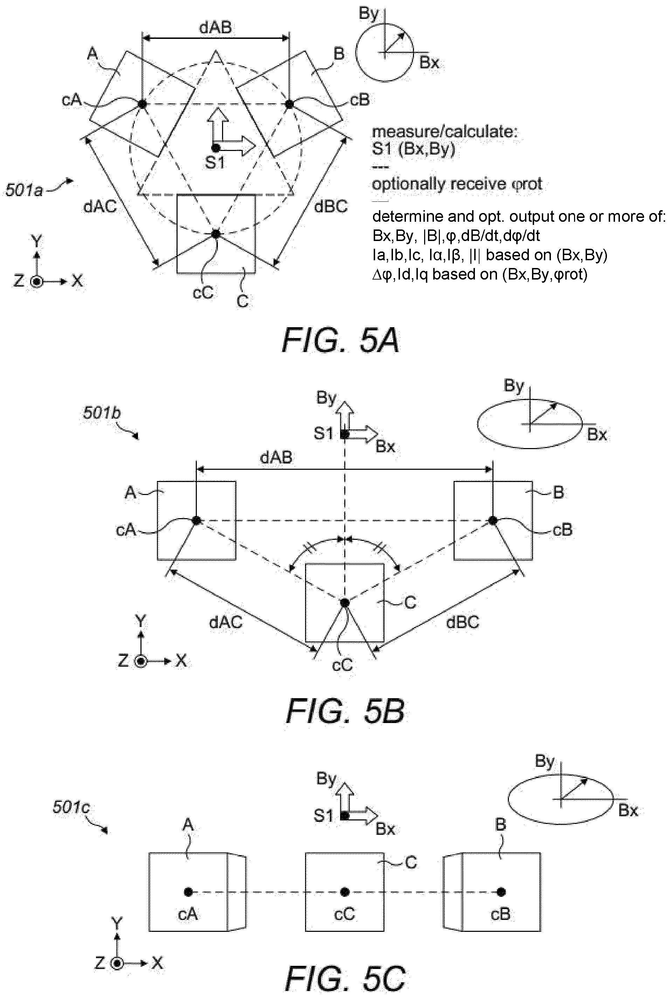

Examples of this embodiment are shown in FIG. 5.

The magnetic sensor may be a 2D magnetic sensor comprising a horizontal Hall element and at least one vertical Hall element; or may comprise a 2D magnetic sensor comprising an **IMC** disk and two horizontal Hall elements located on opposite sides of the **IMC** disk spaced apart 180°; or may be a 2D magnetic sensor comprising at least two vertical Hall elements oriented in perpendicular directions (X, Y).

**In** an embodiment, the first sensor device comprises at least three magnetic sensors spaced apart from each other in one or two directions, each magnetic sensor being configured for measuring at least two, or at least three orthogonal magnetic field components.

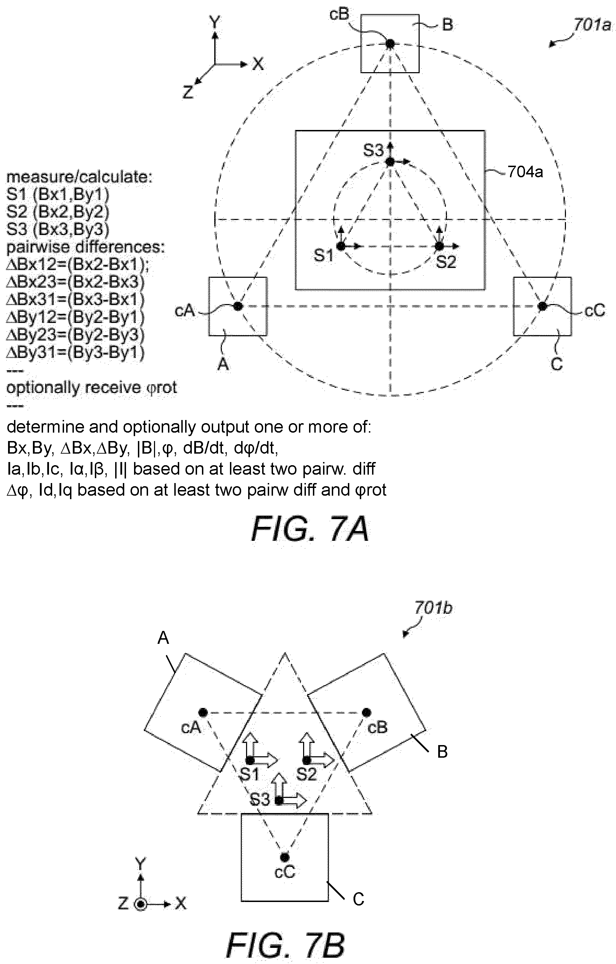

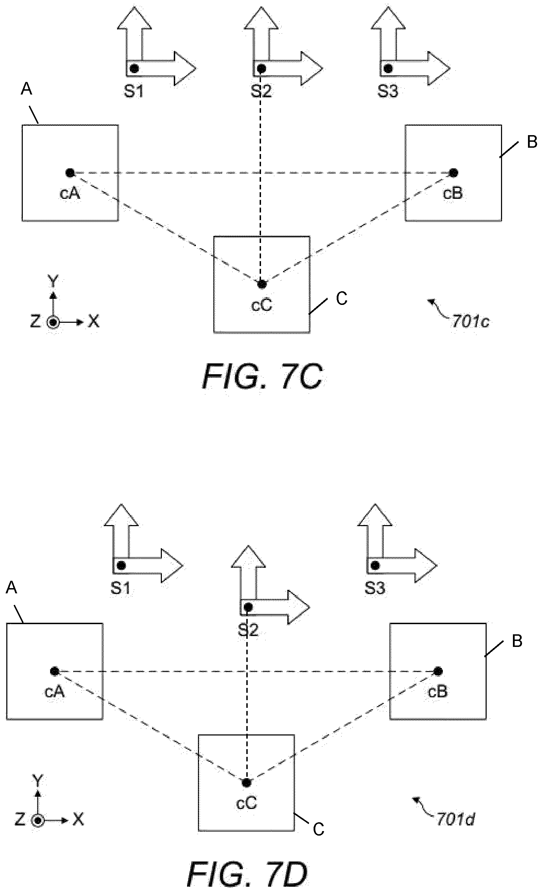

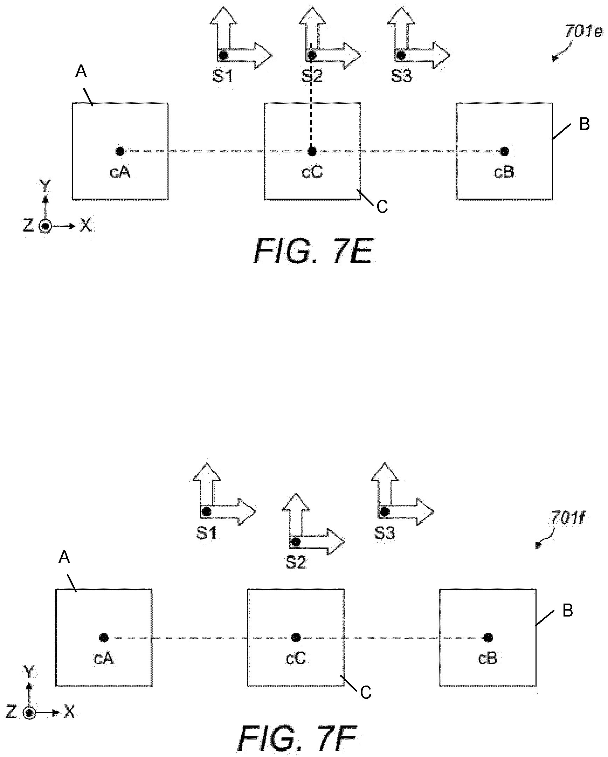

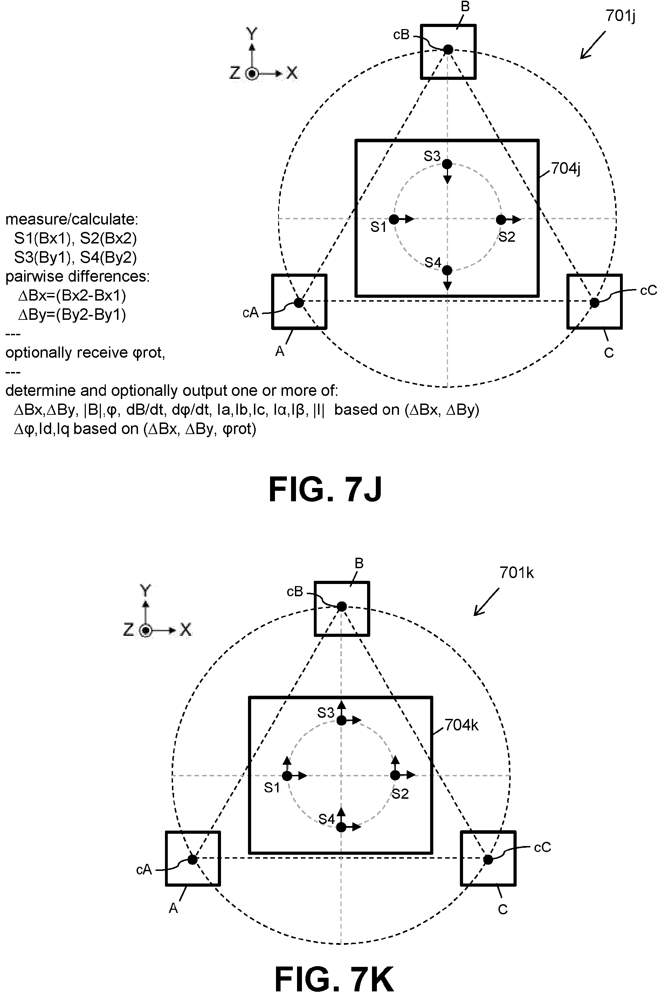

Examples of this embodiment are shown in **FIG. 7****.**

**In** an embodiment, the first sensor device comprises a magnetic sensor configured for measuring three orthogonal magnetic field components at a predefined location.

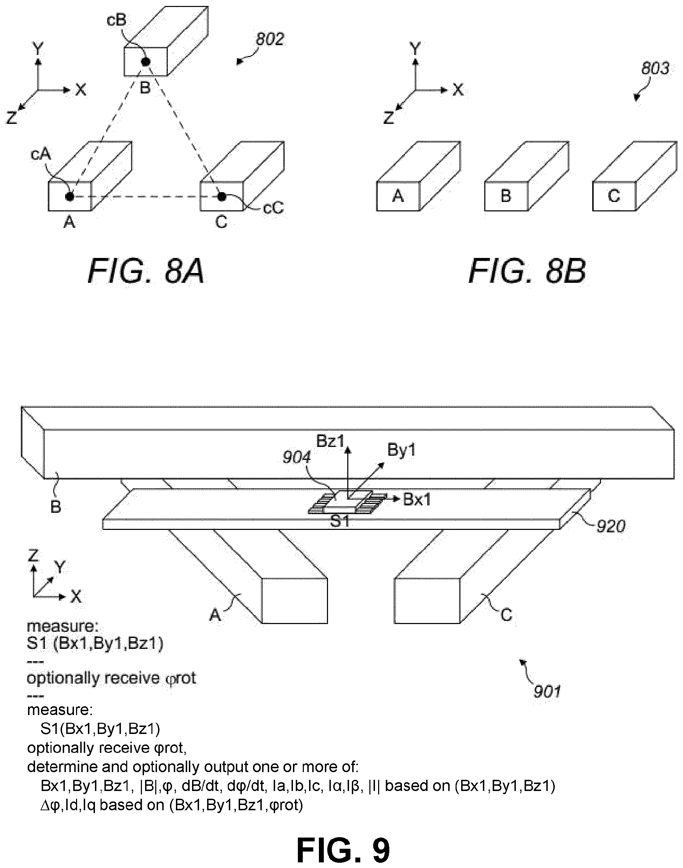

An example of this embodiment is shown in **FIG. 9****.**

The magnetic sensor may be a 3D magnetic sensor comprising an **IMC** disk and four horizontal Hall elements located near a periphery of the **IMC** and spaced apart by multiples of 90°. Alternatively, the magnetic sensor may comprise a horizontal Hall element and two or four vertical Hall elements arranged near two or four sides of the horizontal Hall element.

**In** an embodiment, the plurality of electrical conductor portions are part of two busbars having elongated portions extending in parallel in a first direction.

**In** an embodiment, the plurality of electrical conductor portions are part of three busbars having elongated portions (e.g. A,B,C) extending in parallel in a first direction (e.g. Z), each elongated portion having a centreline (e.g. cA,cB,cC) that intersects with a virtual plane (e.g. XY) oriented perpendicular to the first direction (e.g. Z), and wherein the intersections define an equilateral triangle. Examples of this embodiment are shown in **FIG.** 4A, **FIG.** 4B, **FIG.** 5A, **FIG.** 6A; **FIG.** 7A, **FIG.** 7B, **FIG.** 8A.

**In** an embodiment, the plurality of electrical conductor portions are part of three busbars having elongated portions (e.g. A,B,C) extending in parallel in a first direction (e.g. Z), each elongated portion having a centreline (e.g. cA,cB,cC), wherein the centrelines are located in a single plane;

Examples of this embodiment are shown in **FIG.** 5C, **FIG.** 6C; **FIG.** 7E, **FIG.** 7F, **FIG.** 8B.

**In** an embodiment, the plurality of electrical conductor portions are part of three busbars having elongated portions (e.g. A,B,C) extending in three crossing directions.

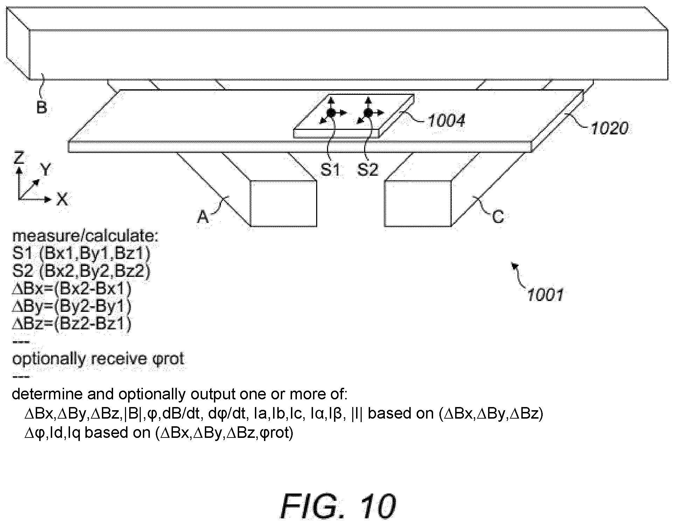

Examples of this embodiment are shown in **FIG.** 9 and **FIG.** 10.

In an embodiment, the electrical conductor portions have a square cross-section, or a rectangular cross-section, or a circular cross-section.

In an embodiment, pairs of magnetic field components or pairs of magnetic field differences or pairs of magnetic field gradients are transformed by performing one or more of the following: a shift operation, a rotation operation, a stretching operation, a scaling operation before determining a norm (e.g. |B| and/or an angle (e.g. ϕ) of the vector of the combined magnetic field.

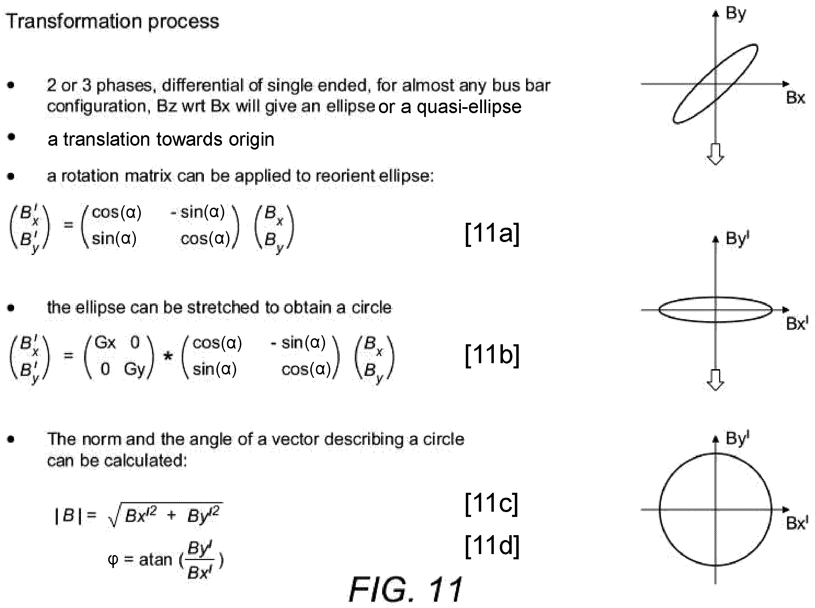

This is illustrated (inter alia) in FIG. 11. The values of the shift operation (X0,Y0), rotation angle (α) and the scaling factor (G) or the scaling factors (Gx, Gy) may be determined by simulation or by a calibration procedure, and may be stored in a non-volatile memory of the first sensor device.

In an embodiment, pairs of magnetic field components or pairs of magnetic field differences or pairs of magnetic field gradients are transformed using a lookup-table with or without interpolation, before determining an angle (ϕ) of the vector of the combined magnetic field.

According to a second aspect, the present invention also provides a motor control system comprising: a sensor system according to the first aspect; an electrical motor having a stator comprising a plurality of coils and having a rotor; wherein the coils of the motor are electrically connected in series with at least some of the electrical conductor portions (e.g. A,B,C) of the sensor system.

In an embodiment, the motor control system further comprises a current controller and a processing circuit configured to perform at least a Reverse Clarke-Park transform; and optionally further comprising a torque convertor.

According to a third aspect, the present invention also provides a method of controlling an electrical motor, comprising the steps of: a) optionally providing a plurality of electrical conductor portions (e.g. A, B, C) for conducting a plurality of electrical currents (e.g. la, Ib, Ic), which together form a combined magnetic field, and providing a first sensor device comprising a plurality of magnetic sensors; x) optionally providing a second sensor device communicatively connected to the first sensor device, the second sensor device being configured for determining an actual angular position (e.g. ϕrot) of the rotor; b) measuring by the first sensor device, at least two magnetic field components (e.g. Bx, By) or at least two magnetic field differences (e.g. ΔBx, ΔBy) or at least two magnetic field gradients of the combined magnetic field generated by the currents (e.g. Ia,Ib,Ic) flowing through the electrical conductor portions (e.g. A, B, C), in one or more sensor locations; y) optionally transforming by the first sensor device, the measured magnetic field components or magnetic field differences or magnetic field gradients, before determining an angle (e.g. ϕ) of the combined magnetic field vector; c) determining and/or outputting, by the first or second sensor device, one or more of the following sets of signals: i) an angular position of the rotor (e.g. ϕrot) and/or one or more magnetic field components (e.g. Bx, By), and/or one or more magnetic field differences (e.g. ΔBx, ΔBy), and/or one or more magnetic field gradients; ii) two or more signals indicative of (e.g. proportional to) the electrical currents (e.g. la, Ib, Ic, Iα,Iβ) flowing in said electrical conductor portions (e.g. A, B, C); ii) one or more signals (e.g. Bx,By; |B|, ϕ) indicative of (e.g. proportional to) a first field vector (e.g. v1) of the combined magnetic field generated by the currents (e.g. la, Ib, Ic) flowing through the electrical conductor portions (e.g. A,B,C) and flowing through the motor coils, and/or one or more signals (e.g. dB/dt, dϕ/dt, Δϕ; Id,lq) derived therefrom, optionally taking into account the rotor position (e.g. ϕrot).

According to a fourth aspect, the present invention also provides a method of controlling an electrical motor, comprising the steps of: a) optionally providing a plurality of electrical conductor portions (e.g. A, B, C) for conducting a plurality of electrical currents (e.g. la, Ib, Ic), which together form a combined magnetic field, and providing a first sensor device comprising a plurality of magnetic sensors; x) optionally providing a second sensor device communicatively connected to the first sensor device, the second sensor device being configured for determining an actual angular position (e.g. ϕrot) of the rotor; b) measuring by the first sensor device, at least two magnetic field components (e.g. Bx, By) or at least two magnetic field differences (e.g. ΔBx, ΔBy) or at least two magnetic field gradients of the combined magnetic field generated by the currents (e.g. Ia,Ib,Ic) flowing through the electrical conductor portions (e.g. A, B, C), in one or more sensor locations; y) optionally transforming by the first sensor device, the measured magnetic field components or magnetic field differences or magnetic field gradients, before determining an angle (e.g. ϕ) of the vector; c) performing by the first or second sensor device at least one of the following: c1) outputting one or more of the measured angular position (e.g. ϕrot) and/or measured or determined magnetic field components (e.g. Bx,By), magnetic field differences (e.g. ΔBx,ΔBy) magnetic field gradients; c2) calculating and/or outputting two or more signals (e.g. la, Ib, Ic, Iα,Iβ) indicative of (e.g. proportional to) the electrical currents (e.g. la, Ib, Ic) flowing in said electrical conductor portions (e.g. A, B, C); c3) calculating and/or outputting one or more signals (e.g. Bx,By; | B|,ϕ) indicative of (e.g. proportional to) a field vector (e.g. v1) of the combined magnetic field generated by the currents (e.g. Ia,Ib,Ic) flowing through the electrical conductor portions (e.g. A, B, C) and flowing through the motor coils, and/or one or more signals (e.g. dB/dt, dϕ/dt, Δϕ; Id,lq) derived therefrom, optionally taking into account the rotor position (e.g. ϕrot); c4) calculating and/or outputting current values (e.g. Id, Iq) in a rotor reference frame (also referred to as "dq-frame"), based on the measured magnetic field values and on the rotor position (e.g. ϕrot).

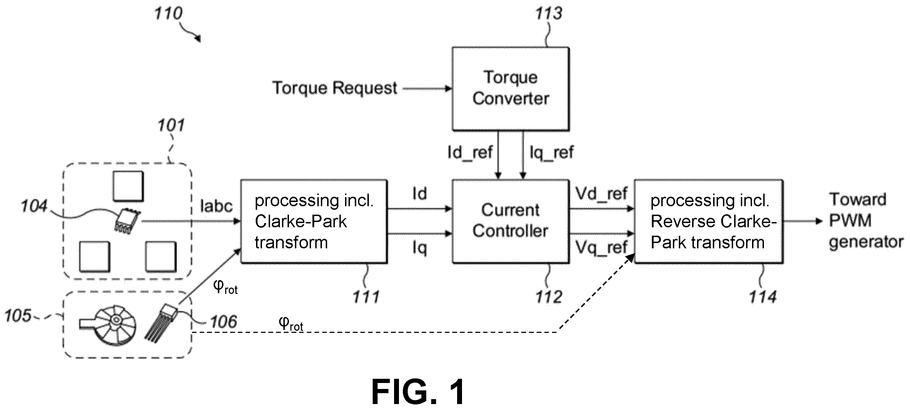

According to a fifth aspect, the present invention also provides a sensor device for use in a sensor system according to the first aspect; the sensor device comprising a plurality of magnetic sensors configured for measuring characteristics of a combined magnetic field generated by a plurality of currents (e.g. Ia,Ib,Ic) flowing in a plurality of electrical conductor portions (e.g. A, B, C); the sensor device being configured to measure at least two magnetic field components (e.g. Bx,By) or at least two magnetic field differences (e.g. ΔBx, ΔBy) or at least two magnetic field gradients of the combined magnetic field in one or more sensor locations; the sensor device optionally being configured to receive a rotor position (e.g. ϕrot); the sensor device being configured to determine and/or output at least one of the following sets of signals: i) said angular position of the rotor (e.g. ϕrot) and/or one or more of said magnetic field components (e.g. Bx,By) and/or one or more of said magnetic field differences or gradients; ii) two or more signals (e.g. la,lb,lc, Iα,Iβ) indicative of (e.g. proportional to) the plurality of electrical currents (e.g. la, Ib, Ic) flowing in said electrical conductor portions (e.g. A, B, C); iii) one or more signals (e.g. Bx,By; |B|,ϕ) indicative of (e.g. proportional to) a first field vector (e.g. v1) of the combined magnetic field, and/or one or more signals (e.g. dB/dt, dϕ/dt, Δϕ; Id,lq) derived therefrom, based on said at least two magnetic field components or said at least two magnetic field differences or said at least two magnetic field gradients, optionally taking into account the received motor position (e.g. ϕrot). Such a sensor device is illustrated in FIG. 1 to FIG. 3 and FIG. 14.

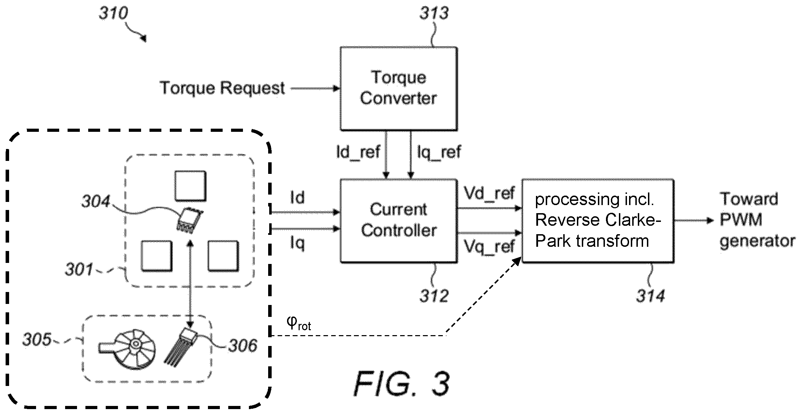

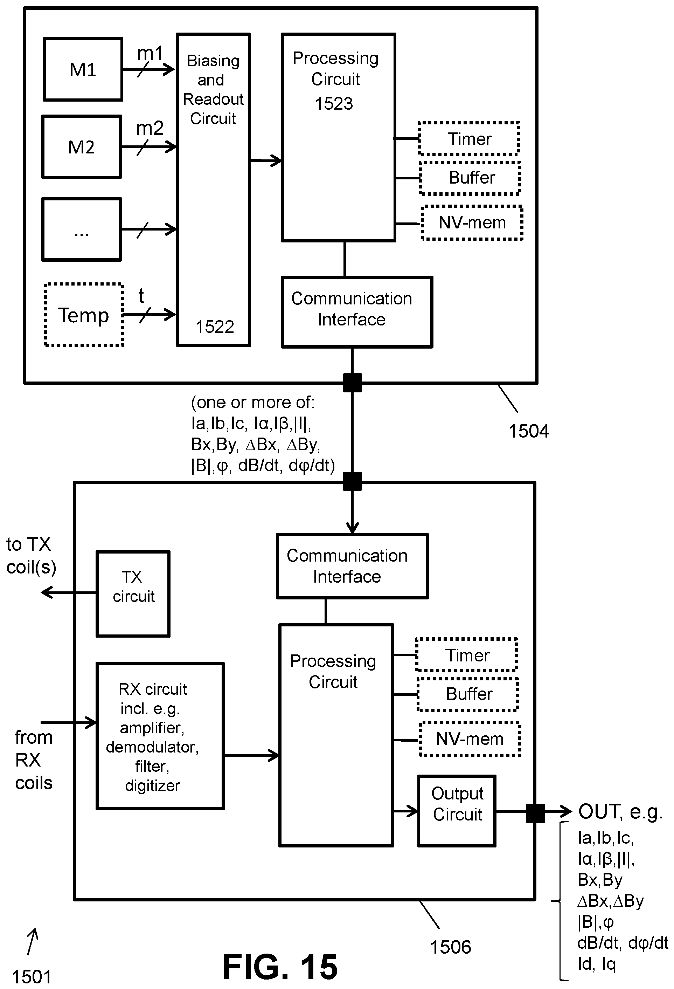

According to a sixth aspect, the present invention also provides a sensor device configured to determine a rotor position (e.g. ϕrot); the sensor device being configured to receive at least two magnetic field components (e.g. Bx,By) or at least two magnetic field differences (e.g. ΔBx, ΔBy) from another sensor device (1504) that is arranged relative to a plurality of conductor portions (e.g. A,B,C); the sensor device being configured to determine and/or output at least one of the following sets of signals: i) said angular position of the rotor (e.g. ϕrot) and/or one or more of said magnetic field components (e.g. Bx,By) and/or one or more of said magnetic field differences or gradients; ii) two or more signals (e.g. la,lb,lc, Iα,Iβ) indicative of (e.g. proportional to) the plurality of electrical currents (e.g. la, Ib, Ic) flowing in said electrical conductor portions (e.g. A, B, C); iii) one or more signals (e.g. Bx,By; |B|,ϕ) indicative of (e.g. proportional to) a first field vector (e.g. v1) of the combined magnetic field, and/or one or more signals (e.g. dB/dt, dϕ/dt, Δϕ; Id,lq) derived therefrom, based on said at least two magnetic field components or said at least two magnetic field differences or said at least two magnetic field gradients, optionally taking into account the received motor position (e.g. ϕrot). Such a sensor device is illustrated in FIG. 15, as a variant of FIG. 3.

According to another aspect, the present invention is related to a **multiphase metering system** (also referred to as a power consumption meter) comprising a sensor system according to the first aspect and/or comprising a current sensor device according to the fifth or the sixth aspect.

According to another aspect, the present invention is related to an **electrical power converter** comprising a sensor system according to the first aspect and/or comprising a current sensor device according to the fifth or the sixth aspect.

Particular and preferred aspects of the present invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

**FIG. 1 to FIG. 3** show illustrative examples of a high-level block-diagram of a portion of a field-oriented motor control system, comprising a sensor system proposed by the present invention.
**FIG. 4A to FIG. 10** show illustrative examples of sensor systems proposed by the present invention, as can be used in field-oriented motor control system like the ones shown in FIG. 1 to FIG. 3.
**FIG. 4A and FIG. 4B** show illustrative examples of sensor systems, comprising three parallel conductor portions extending in a direction (Z), and a sensor device for measuring magnetic field components in a plane (XY) perpendicular to the conductor portions.
FIG. 4A and FIG. 4B may be jointly referred to as **FIG. 4****.**
**FIG. 5A** shows an illustrative example of a cross-section of a sensor system similar to the one of FIG. 4A or FIG. 4B, where centrelines of the three parallel conductor portions intersect the plane XY in three points situated at the corners of a virtual equilateral triangle, and the sensor device is configured to measure two orthogonal field components at a sensor location situated inside said triangle, e.g. in the centre of the triangle.
**FIG. 5B** shows a variant of FIG. 5A, where centrelines of the three parallel conductor portions intersect the plane XY in three points situated at the corners of an isosceles but not equilateral triangle, and the sensor device is configured to measure two orthogonal field components at a sensor location situated outside of said triangle, e.g. on a bisector of said triangle.
**FIG. 5C** shows another variant of FIG. 5A, where centrelines of the three parallel conductor portions are located in a plane XZ and are spaced apart equidistantly, and the sensor device is configured to measure two orthogonal field components at a sensor location situated outside of said plane, e.g. at a predefined distance above or below the plane, e.g. above the central conductor portion.
FIG. 5A to FIG. 5C may be jointly referred to as **FIG. 5****.**
**FIG. 6A** shows a variant of FIG. 5A, wherein the sensor device is configured to measure a set of orthogonal magnetic field components in each of two sensor locations situated inside the triangle.
**FIG. 6B** shows a variant of FIG. 5B, wherein the sensor device is configured to measure a set of orthogonal magnetic field components in each of two sensor locations situated outside of the triangle.
**FIG. 6C** shows a variant of FIG. 5C, wherein the sensor device is configured to measure a set of orthogonal magnetic field components in each of two sensor locations situated outside of the plane.
**FIG. 6D** shows a variant of FIG. 6A where the conductor C is shifted slightly upwards.
FIG. 6A to FIG. 6D may be jointly referred to as **FIG. 6****.** It is noted that the sensor device itself is not shown, but the sensor locations are shown.
**FIG. 7A** shows a variant of FIG. 6A, wherein the sensor device is configured to measure a set of orthogonal magnetic field components in each of three sensor locations situated inside the equilateral triangle.
**FIG. 7B** shows a variant of FIG. 7A in a more compact arrangement.
**FIG. 7C** shows a variant of FIG. 6B, wherein the sensor device is configured to measure a set of orthogonal magnetic field components in each of three sensor locations situated outside of the triangle, the three sensor locations are situated on a virtual line.
**FIG. 7D** shows a variant of FIG. 7C, wherein the three sensor locations are not situated on a virtual line. At least two sensor locations are situated outside of the virtual triangle.
**FIG. 7E** shows a variant of FIG. 6C, wherein the sensor device is configured to measure a set of orthogonal magnetic field components in each of three sensor locations situated outside of the plane, the three sensor locations are situated on a virtual line.
**FIG. 7F** shows a variant of FIG. 7E, wherein the three sensor locations are not situated on a virtual line.
**FIG. 7G** show a variant of FIG. 7A.
**FIG. 7H** and **FIG. 7I** shows variants of FIG. 7G.
**FIG. 7J** and FIG. 7K show other variants of FIG. 7A.
FIG. 7A to FIG. 7K may be jointly referred to as **FIG. 7****.**
**FIG. 8A** shows three conductor portions as may be used in the sensor system of FIG. 4A to FIG. 5A, FIG. 6A, FIG. 7A, FIG. 7B.
**FIG. 8B** shows three conductor portions as may be used in the sensor system of FIG. 5C, FIG. 6C, FIG. 7E and FIG. 7F.
FIG. 8A and FIG. 8B may be jointly referred to as **FIG. 8****.**
**FIG. 9** shows a variant of FIG. 4A and FIG. 4B comprising three electrical conductor portions crossing each other, and a single 3D magnetic sensor arranged in the vicinity of the conductor portions.
**FIG. 10** shows a variant of FIG. 9 comprising three electrical conductor portions crossing each other, and two 3D magnetic sensors arranged in the vicinity of the conductor portions.
**FIG. 11** illustrates a technique that may be used in embodiments of the present invention. The technique shows how two values describing an ellipse, can be converted into a set of values describing a circle, and how a magnitude and phase of that circle can be determined.

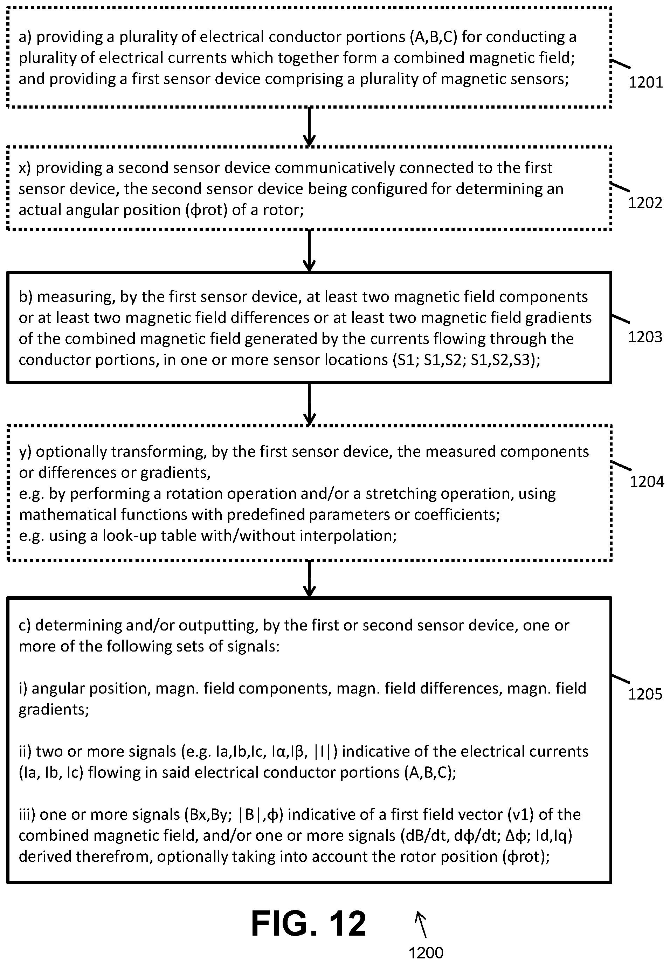

**FIG. 12** shows a flow-chart of a method of controlling an electrical motor, proposed by the present invention.

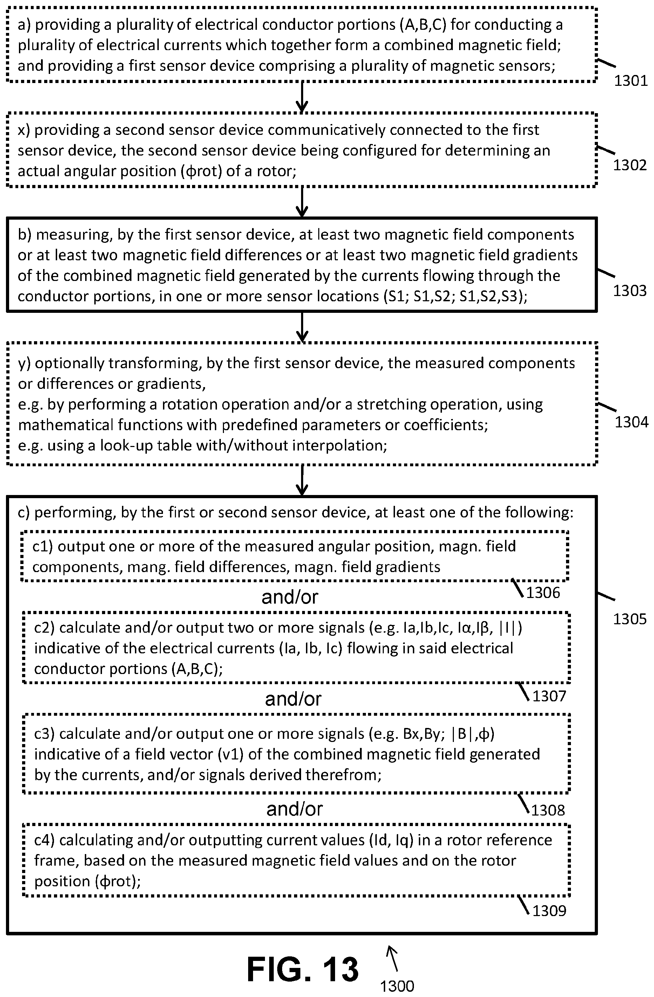

**FIG. 13** shows another flow-chart of a method of controlling an electrical motor, according to an embodiment of the present invention.

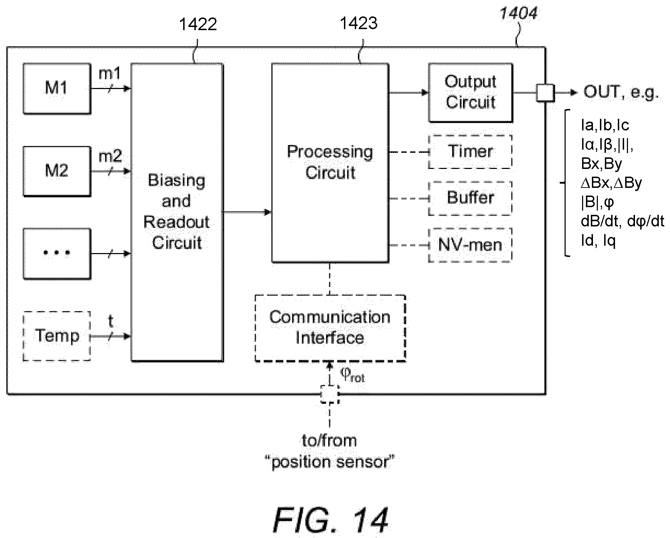

**FIG. 14** shows an illustrative example of a block-diagram of a "first sensor device" as can be used in embodiments of the present invention.
**FIG. 15** shows an illustrative example of a block-diagram of a sensor system comprising a first and a second sensor device, as can be used in embodiments of the present invention.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The same or similar reference numerals (modulo 100) may be used to indicate same or similar structural features in different embodiments.

In this document, unless explicitly mentioned otherwise, the term "magnetic sensor device" or "first sensor device" refers to a device comprising at least two "magnetic sensor elements", preferably integrated in a semiconductor substrate. The sensor device may be comprised in a package, also called "chip", although that is not absolutely required.

In this document, the term "sensor element" or "magnetic sensor element" or "magnetic sensor" can refer to a component or a group of components or a sub-circuit or a structure capable of measuring a magnetic quantity, such as for example a magneto-resistive (MR) element, an AMR element, a GMR element, a TMR element, an XMR element, a horizontal Hall plate, a vertical Hall plate, a Wheatstone-bridge containing at least one (but preferably four) magneto-resistive elements, etc. or combinations hereof.

In embodiments of the present invention, the term "magnetic sensor" or "magnetic sensor structure" may refer to an arrangement comprising one or more integrated magnetic concentrators (IMC), also known as integrated flux concentrators, and one or more horizontal Hall elements arranged near the periphery of the IMC, for example a disk shaped IMC with four horizontal Hall elements angularly spaced by multiples of 90°.

In this document, the expression "2D magnetic sensor" or "2D magnetic pixel" mean the same.

In this document, the expression "3D magnetic sensor" or "3D magnetic pixel" mean the same.

Embodiments of the present invention (see e.g. FIG. 4A to FIG. 8B) may comprise parallel conductor portions. These embodiments may be described using an orthogonal coordinate system fixedly connected to said plurality of electrical conductor portions, where the Z-axis is parallel to the electrical conductor portions, and the X and Y axis are perpendicular to the electrical conductor portions.

Embodiments of the present invention (see e.g. FIG. 9 and FIG. 10) where the conductor portions are not oriented parallel, may also be described using a coordinate system XYZ that is fixedly connected to the conductor portions, but the Z-axis in these figures is oriented upwards in the drawing, and is not necessarily oriented in the same direction as any of the conductor portions.

In this document, the expression "spatial derivative" or "derivative" or "spatial gradient" or "gradient" are used as synonyms. If the order of the derivative is not explicitly mentioned, a first order gradient is meant, unless clear from the context otherwise. In the context of the present invention, the gradient is typically determined as a difference between two values measured at two locations spaced apart along a certain direction. In theory the gradient is typically calculated as the difference between two values divided by the distance between the sensor locations (e.g. dx), but in practice the division by said distance is often omitted, because the measured signals need to be scaled anyway. Hence, in the context of the present invention, the expression "magnetic field difference" and "magnetic field gradient" can be used interchangeably.

Unless clear from the context otherwise, in this document Δx and dx mean the same.

In this document, the abbreviation labc can be used to represent three currents la,lb,lc.

In this document, the currents lu, Iv, Iw flowing through the electrical conductor portions, and the currents la, Ib, Ic flowing through motor coil windings are the same, unless explicitly mentioned otherwise.

In this document, a pair of two values e.g. (Bx, By) or (ΔBx, ΔBy) are referred to as "elliptical values" if they describe an ellipse-like curve (e.g. as shown in FIG. 11 top or middle), i.e. before transformation.

In this document, a pair of two values e.g. (Bx', By') or (ΔBx', ΔBy') are referred to as "circular values" if they describe a circular curve (e.g. as shown in FIG. 11 bottom), i.e. after transformation. In embodiments of the present invention, the transformation from "elliptical values" to "circular values" can be implemented e.g. using a lookup-table, optionally with interpolation; or can be implemented using mathematical formulas (e.g. [11a] and/or [11b]) with predefined parameters or coefficients (e.g. the value of a, Gx, By of FIG. 11), which may be determined during a calibration procedure, and may be written in a non-volatile memory of the sensor system.

In this document, S1, S2, S3 may refer to a first, second, third sensor location, or to a first, second, third magnetic sensor situated at this location. It will be clear from the context which meaning is intended.

In this document, the expression "quasi circle" refers to a closed curve that very much resembles a circle, or stated more accurately, a closed curve that is located between an imaginary inner circle and an imaginary outer circle, concentric with the inner circle, and having a radius that is at most 10% larger than the radius of the inner circle.

In this document, the expression "quasi ellipse" refers to a closed curve that very much resembles an ellipse, or stated more accurately, a closed curve that is located between an imaginary first ellipse and an imaginary second ellipse which is a scaled version of the first ellipse, where the scaling factor is at most 110%.

The present invention relates in general to current sensing, and more in particular to devices and methods and systems for measuring currents, in particular multiphase currents as can be used for example in electrical power meters, in electrical power converters (e.g. PV solar inverters, wind turbine converters) or in motor control systems, for example AC Induction Machines (ACIMs) or Field-Oriented-Control (FOC) motor control systems, or Direct Torque Control (DTC) motor control systems. The present invention can be used in electrical vehicles, but the present invention is not limited to automotive applications, and can also be used in domestic and industrial applications.

In this document, the rotor position is typically provided as an angle value "ϕrot", but that is not absolutely required, and it is also possible to provide a rotor position using a sine and a cosine signal. The same is true when providing a phase of a sinusoidal voltage waveform. For simplicity, however, the description typically only mentions ϕrot.

### Referring to the Figures.

**FIG. 1 to FIG. 3** show illustrative examples of a high-level block-diagram of a portion or subsystem of a field-oriented motor control system 110. Typical motor control systems for electrical vehicles are very complex, and may comprise a feedback-loop with a speed sensor for trying to match a desired speed, and/or a feedback loop with a torque sensor for trying to match a desired torque. FIG. 1 to FIG. 3 show only a portion of such a complete motor control system, relevant for the present invention.

**FIG. 1** shows a sensor system 101 configured for measuring (directly or indirectly) currents flowing through the coils of the electrical motor (not explicitly shown), and for providing a plurality of current signals (e.g. la, Ib, Ic) to a processing block 111 including at least a Clarke-Park Transform. The block 111 also receives a rotor position ϕrot, from an angular position sensor 105 (e.g. an inductive angular position sensor), or a sine and a cosine signal from which the angle ϕrot can derived, and converts the multi-phase current signals la, Ib, Ic measured or expressed in the so called "abc frame" in two orthogonal components Iα, Iβ in a static "αβ-frame", and further into Id, Iq signals expressed in a so called "dq frame", using a Clarke-Park transformation, known per sé in the art. Readers unfamiliar with the Clarke-Park transformation can find a nice animation on the following website: https://www.mathworks.com/discovery/Clarke-and-Park-transforms.html, which may help to better understand aspects of the present invention. The signals Id, Iq are indicative of (e.g. proportional to) the torque exerted upon the rotor by the magnetic field generated by the currents la, Ib, Ic flowing through the stator coils. In current controller block 112, the actual signals Id, Iq are compared with reference values of Id and Iq (e.g. Id_ref, Iq_ref) derived from a desired torque, or a torque request signal, and converted into reference voltage values Vd_ref, Vq_ref, which are applied to a processing block 114 including at least a Reverse Clarke-Park transform, to be converted back to voltages in the "abc frame", for further processing. The block 114 may obtain the angle ϕrot from the position sensor 105 or from any of the blocks 111, 112, depending on the implementation.

The sensor system 101 is depicted in FIG. 1 as a picture with a plurality of electrical conductor portions (represented by three squares for reasons that will become clear later) and a sensor chip arranged in the vicinity of these conductor portions. In order to understand the principles of FIG. 1, it suffices to know that the sensor chip 104 of FIG. 1 is capable of measuring characteristics of the magnetic fields generated by the currents flowing through the conductor portions (which are the same currents that flow through the motor coils), and is capable of determining and outputting these current signals or values la, Ib, Ic. The sensor device 104 may comprise one or more 1D or 2D or 3D magnetic pixels, and/or may be configured to measure magnetic field component or magnetic field differences. The electrical conductor portions may be arranged in 3D space, or may be situated in a plane, etc. This will be described in more detail further.

For completeness it is noted that the angular position sensor 105 is illustrated in the example of FIG. 1 as an inductive angular position sensor having a printed circuit board (PCB) with a plurality of coils, and a target having five lobes, and an integrated circuit 106 (also referred to herein as "second sensor device") in a package with elongated leads, but of course, the present invention is not limited thereto, and inductive position sensors with a target having more than five lobes or less than five lobes, and/or having an integrated circuit 106 in a package that is soldered on the PCB, can also be used. In fact, non-inductive angular position sensors can also be used, but may be more expensive.

The sensor system 101 may be considered or referred to as a "current sensor system", and the sensor device 104 may be referred to herein as "first sensor device" or "current sensor device", even though it does not physically measure individual currents, but actually measures characteristics of a combined magnetic field generated by the currents, and computes the currents from these magnetic field characteristics.

In a three-phase system, the currents la, Ib, Ic can be referred to as the "three phase currents", the currents Iα, Iβ can be referred to as the two-phase currents. It is also possible to determine and optionally output the norm |I| of the current, which can be derived from la, Ib, Ic and/or from Iα, Iβ (e.g. as a square root of the sum of the square of Iα and the square of Iβ).

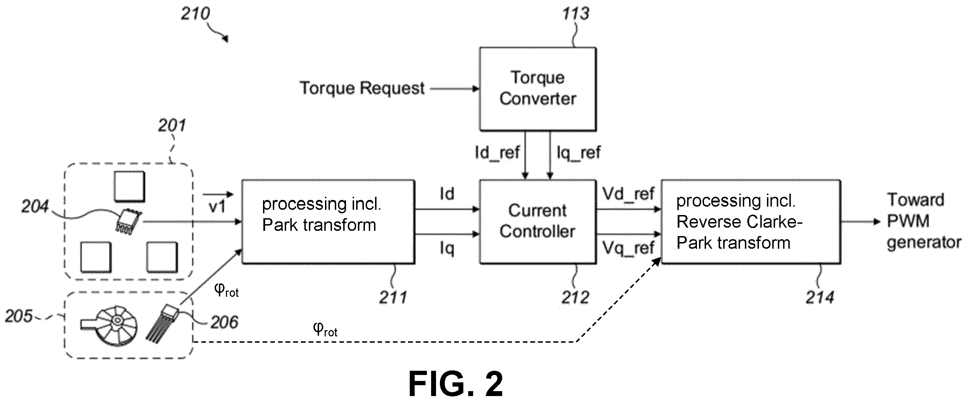

**FIG. 2** shows another illustrative example of a portion of a field-oriented motor control system 210. FIG. 2 can be seen as a variant of FIG. 1, the main differences being that:
(i) the processing block 211 of FIG. 2 is not configured to perform a Clarke-Park transform, but only a Park transform;
(ii) the sensor system 201 of FIG. 2 does not provide three currents la, Ib, Ic but provides information related to the combined magnetic field generated by the currents, which is related to (e.g. a copy of, or a mirror of, or a transform of) the magnetic field vector experienced by the rotor in the motor, or values derived therefrom. In the example of FIG. 2, the sensor device 204 provides vector information v1, which may be provided e.g. in the form of two orthogonal magnetic field components (e.g. Bx, By), and/or in the form of an amplitude and a phase (e.g. |B|, ϕ), and/or values derived herefrom, such as e.g. dB/dt, dϕ/dt.

Everything else described above for FIG. 1 is also applicable for FIG. 2, mutatis mutandis.

**FIG. 3** shows another illustrative example of a portion of a field-oriented motor control system 310. FIG. 3 can be seen as a variant of FIG. 1, or as a further variant of FIG. 2, wherein:
(i) the motor control system 310 of FIG. 3 does not comprise a processing block 211 that performs a Clarke-Park transform, or a processing block 211 that performs a Clarke transform;
(ii) the sensor system 301 of FIG. 3 does not provide three currents la, Ib, Ic but provides Id, Iq signals in a "dq" reference frame that rotates along with the rotor of the motor;
(iii) the angular position sensor 305 is communicatively connected to the sensor device 304.

Everything else described above for FIG. 1 and FIG. 2 is also applicable for FIG. 3, mutatis mutandis.

It is a major advantage of the embodiment of FIG. 3 that the high-speed processing is now mainly concentrated in the sensor device 304.

In the embodiment of FIG. 3, the first sensor device 304 (also referred to herein as "current sensor device") and the second sensor device 306 (also referred to herein as "angular sensor device") are preferably communicatively connected via a unidirectional or a bidirectional high-speed digital interface. Ideally, the measurements of the magnetic field performed by the first sensor device 304 and the measurements of the angular rotor position performed by the second sensor device 306 occur simultaneously, and the processing of these signals happens instantaneously, but in practical implementations, it suffices that the signals are acquired and processed within a predefined time window (e.g. substantially at the same time).

In certain embodiments, the acquisitions by each sensor device 304, 306 occur independently and asynchronously. In preferred embodiments, the acquisitions occur synchronously. In an embodiment, the current sensor device 304 triggers the measurement performed by the position sensor device 306. In another embodiment, the position sensor device 306 triggers the measurements performed by the current sensor device 304. Alternatively or additionally, data from previous measurements (magnetic field values, angular position values, or both) can be used to time the acquisition. For example, it may be beneficial to trigger the measurement at a specific timing of the driving sequence. The data acquisition rate and the data output rate of the first and/or second sensor device 304, 306 may be identical (e.g. clock synchronous), but that is not absolutely required, and it is also possible to buffer data (magnetic field values, angular position values, or both) from previous measurements in a buffer, optionally together with a time-stamp, and to determine the output data at a different rate, using interpolation and/or extrapolation of the data stored in the buffer.

In a variant of FIG. 3, illustrated in FIG. 15, the first sensor device 1504 and the second sensor device 1506 are both part of the "current sensor system" 1501; and the first sensor device 1504 is arranged in the vicinity of the electrical conductor portions, and is configured to measure characteristics of the combined magnetic field; and the second sensor device 1506 is configured to determine the actual angular position of the rotor; but in this embodiment, the first sensor device 1504 provides information (e.g. measured magnetic field components Bx, By; or magnetic field differences ΔBx, ΔBy; optionally transformed using a lookup-table or using the techniques of FIG. 11) to the second sensor device 1506, and the second sensor device 1506 is configured to further process the information, and to provide Id, Iq signals to the Current controller block 312. In an embodiment, the transformation from "elliptical values" to "circular values" is implemented in the first sensor device 1504. In another embodiment, the transformation from "elliptical values" to "circular values" is implemented in the second sensor device 1506. This transformation will be described further, e.g. in FIG. 11, although the present invention is not limited to the technique described in FIG. 11, and other techniques, e.g. based on a lookup-table, can also be used.

**FIG. 4A to FIG. 10** show illustrative examples of "sensor systems" 101, 201, 301 as can be used in field-oriented motor control system 110, 210, 310, portions of which are shown in FIG. 1 to FIG. 3.

The sensor systems 101, 201, 301 comprise:
- a plurality of electrical conductor portions (e.g. three busbar portions A, B, C), and
- a first sensor device 104, 204, 304 arranged in the vicinity of the electrical conductor portions and having a plurality of magnetic sensor elements.

The plurality of electrical conductor portions A, B, C (e.g. two to six busbar portions, e.g. three busbar portions) are spaced apart from each other, and are configured for conducting a plurality of electrical currents (e.g. lu, Iv, Iw also referred to herein as la, Ib, Ic) of a multiphase (or polyphase) current system, wherein each current will generate a respective magnetic field. These magnetic fields are superimposed to form a combined magnetic field. Each of the electrical conductor portions A, B, C is preferably electrically connected in series with a coil (or winding) of the electrical motor to be controlled (not explicitly shown). The electrical conductor portions A, B, C may be parts of busbars arranged for powering said motor. The three conductor portions may be physically arranged parallel to each other but spaced apart in 3D space equidistantly (e.g. as illustrated in FIG. 5A, FIG. 6A, FIG. 7A, FIG. 7B, FIG. 8A), or spaced apart in 3D space but not equidistantly (e.g. as illustrated in FIG. 5B, FIG. 6B, FIG. 7C, FIG. 7D), or may be parallel to each other and situated in a virtual plane (e.g. as illustrated in FIG. 5C, FIG. 6C, FIG. 7E, FIG. 7F, FIG. 8B), or not parallel to each other but crossing each other (e.g. as illustrated in FIG. 9 or FIG. 10). Even though each of the illustrative examples shows three conductor portions A, B, C for conducting the electrical currents of a three-phase system, the present invention is not limited thereto, and the principles of the present invention will also work for a two-phase current system, or a polyphase current system having more than three phases, e.g. four phases or five phases or six phases.

The first sensor device 104; 204; 304, 404a, 404b, 704a, 704g, 904, 1004, 1404, 1504 comprises a plurality of magnetic sensors and/or magnetic sensor elements (not shown in FIG. 4, but see e.g. FIG. 5A to FIG. 7K, and FIG. 9 to FIG. 10) configured for measuring characteristics of the combined magnetic field. Various sensor arrangements are possible, configured for measuring one or more magnetic field components in one or more sensor locations, for example:
- the first sensor devices shown in FIG. 5A to FIG. 5C comprise a 2D magnetic pixel for measuring a set of two orthogonal magnetic field components (Bx, By) at a single sensor location S1;
- the first sensor device 904 of FIG. 9 comprises a 3D magnetic pixel for measuring a set of three orthogonal magnetic field components (Bx1, By1, Bz1) at a single sensor location S1;
- the first sensor devices of FIG. 6A to FIG. 6C comprise two 2D magnetic pixels for measuring a set of two orthogonal magnetic field components (Bx, By) at each of a first and a second sensor location S1, S2, and are preferably further configured for determining two magnetic field differences ΔBx, ΔBy or gradients;
- the first sensor device 1004 of FIG. 10 comprises two 3D magnetic pixels for measuring a first set of three orthogonal magnetic field components (Bx1, By1, Bz1) at a first sensor location S1, and a second set of three orthogonal magnetic field components (Bx2, By2, Bz2) at a second sensor location S2;
- the first sensor devices of FIG. 7A to FIG. 7C comprise three 2D magnetic pixels for measuring a set of two orthogonal magnetic field components (Bx, By) at each of a first, second and third sensor location S1, S2, S3;
but other magnetic sensor devices can also be used, e.g. magnetic sensor device having four sensor locations, or magnetic sensor devices comprising only 1D magnetic pixels but oriented in different directions, or magnetic sensor devices comprising 2D or 3D magnetic pixels and further comprising 1D magnetic pixels oriented in one or more direction, etc.

In embodiments of the present invention, the first sensor device 104; 204; 304, 404a, 404b, 704a, 704g, 904, 1004, 1404, 1504 may be an integrated semiconductor device, e.g. a semiconductor substrate at least partially surrounded by a moulding compound (also known as "a chip"), or may be a single packaged device comprising more than one semiconductor substrate (e.g. two semiconductor substrates, or three semiconductor substrates), or may be a printed circuit board comprising more than one packaged device (e.g. as illustrated in FIG. 10). In preferred embodiments of the present invention, the first sensor device comprises only one semiconductor substrate.

In some embodiments of the present invention, the first sensor device may be further configured to determine two or more pairwise differences or gradients (e.g. ΔBx and ΔBy as illustrated in FIG. 6A, or one or more or some or all of ΔBx12, ΔBx23, ΔBx31, ΔBy12, ΔBy23, ΔBy31 as illustrated in FIG. 7A, or ΔBx, ΔBy, ΔBz as illustrated in FIG. 10) between parallel magnetic field components.

In some embodiments of the present invention, the gradients being used for determining the characteristics of the combined magnetic field or values derived therefrom (e.g. one or more of: la, Ib, Ic, v1, |B|, ϕ, dB/dt, dϕ/dt, Id, Iq) depend on the actual (e.g. previous or latest or estimated or predicted) rotor position ϕrot or depends on the actual (e.g. previous or latest or estimated or predicted) orientation of the combined magnetic field. In this way the signal-to-noise ratio (SNR) may be improved.

As already described above (see FIG. 1 to FIG. 3), the first sensor device 104, 204, 304, 1404 may be configured to output (see FIG. 1) a plurality of currents la, Ib, Ic flowing through the electrical conductor portions A, B, C, and/or to output (see FIG. 2) characteristics (e.g. two magnetic field components Bx, By, or an amplitude |B| and a phase ϕ, or two magnetic field differences ΔBx, ΔBy) of the magnetic field vector of the combined magnetic field generated by those currents, and/or may be configured (see FIG. 3) to output two currents Id, Iq in the so called "dq"-frame that rotates along with the rotor.

In a variant (e.g. illustrated in FIG. 15), the output, e.g. the Id, Iq currents can be provided by the second sensor device 1506 rather than the first sensor device. In this embodiment, the first sensor device 1504 provides information related to, or derived from the combined magnetic field (e.g. one or more of the following: la, Ib, Ic, Bx,By, ΔBx, ΔBy, |B|, ϕ, dB/dt, dϕ/dt) to the second sensor device 1506. In an embodiment, the values of (Bx,By) or (ΔBx,ΔBy) are "elliptical values", and the first sensor device 1504 is configured for converting these values into "circular values" (Bx',By') or (ΔBx',ΔBy'), and these converted values are provided to the second sensor device 1506. In another embodiment, the first sensor device provides the "elliptical values" to the second sensor device, and the conversion to "circular values" is performed by the second sensor device. Of course, in this case the second sensor device 1506 needs to know the conversion parameters or coefficients or the look-up table.

In some embodiments, the electrical conductor portions A, B, C are parallel to each other, and the one or more semiconductor substrates of the first sensor device 104, 204, 304, 404a are located in a virtual plane perpendicular to these parallel conductor portions (e.g. as illustrated in FIG. 4A). Or stated in other words, a normal to the semiconductor substrate(s) is parallel to the electrical conductor portions A, B, C. In this embodiment, the at least two magnetic field components measured are preferably "in-plane components", oriented parallel to the semiconductor substrate, parallel to the XY plane.

In some embodiments, the electrical conductor portions A, B, C are parallel to each other and extending in a predefined direction (e.g. Z), and the one or more semiconductor substrates of the first sensor device 104, 204, 304, 404b are parallel to the Z-direction. (e.g. as illustrated in FIG. 4B). In this embodiment, one of the at least two magnetic field components is preferably measured in the X-direction, i.e. is an "in-plane component" oriented parallel to the semiconductor substrate and perpendicular to the Z-direction, and the other of the at least two magnetic field components is preferably measured in the Y-direction, i.e. is an "out of plane component" oriented perpendicular to the semiconductor substrate.

In some embodiments (see e.g. FIG. 9 and FIG. 10), the electrical conductor portions A, B, C are not parallel to each other, but are crossing each other. In this embodiment, it is preferred to measure three orthogonal magnetic field components Bx, By, Bz in one or more sensor locations.

And last but not least, it was surprisingly found that two orthogonal magnetic field components (e.g. Bx1, By1 in FIG. 5A to FIG. 5C), or two orthogonal magnetic field differences (e.g. ΔBx, ΔBy in FIG. 6A to FIG. 6C) describe a circle, or an ellipse, or a curve that closely resembles an ellipse, even if the three conductor portions are not equidistantly spaced from each other, and even if the sensor location is not situated exactly in the middle of the virtual triangle (e.g. as illustrated in FIG. 4A or FIG. 4B). This is particularly true if the sensor location S1 is located in a symmetry-plane of the parallel conductor portions (e.g. as illustrated in FIG. 5B), or if the two sensor locations S1, S2 for which a pairwise difference is determined are located on opposite sides of, and at equal distances of a symmetry-plane of the parallel conductor portions (e.g. as illustrated in FIG. 6B). The inventors surprisingly found that it is possible to determine (e.g. calculate) correct signals for the combined magnetic field in the motor, using an conductor arrangement that is more compact (e.g. as illustrated in FIG. 5B, FIG. 6B, FIG. 7C, FIG. 7D) or even using an arrangement where the electrical conductor portions are situated in a virtual plane (e.g. as illustrated in FIG. 5C, FIG. 6C, FIG. 7E, FIG. 7F). This will be described further in FIG. 11.

It is a major advantage of the present invention that it does not require the electrical conductor portions to be spaced apart at exactly the same dimensions of the electrical motor (e.g. as illustrated in FIG. 8A), but (1) can be miniaturized or scaled, and (2) its height can be reduced without reducing the width, and (3) the conductor portions can even be located in a single plane. Thus, the present invention allows to use a conductor arrangement that is more compact and more convenient than prior art solutions.

These are the main principles underlying the present invention.

The present invention will now be further explained and illustrated using particular examples.

**FIG. 4A** shows an illustrative example of a sensor system 401a, (also referred to herein as "current sensor system") comprising three parallel conductor portions A, B, C extending in the direction Z, and a sensor device 404a (also referred herein to as "first sensor device") for measuring magnetic field characteristics at one or more sensor locations in a plane XY perpendicular to the electrical conductor portions. In the specific example shown in FIG. 4A, the electrical conductor portions A, B, C have rectangular cross-sections with centrelines cA, cB, cC which are equidistantly spaced from each other, and the sensor device 404a is located substantially in the middle between the three conductor portions A, B, C and has one or more semiconductor substrates oriented parallel to the plane XY, but as already mentioned above, none of these characteristics are absolutely required for the invention to work. The sensor device 404a may comprise one or more 1D or 2D or 3D magnetic sensors (not shown in FIG. 4A), for measuring magnetic field components parallel to the XY plane, e.g. a single sensor location S1 where two orthogonal magnetic field components Bx, By are measured; or two sensor locations spaced apart from other, including a first sensor location S1 where Bx is measured, and a second sensor location S2 where By is measured; or at least two sensor locations spaced apart from each other, in each of which two orthogonal magnetic field components Bx and By are measured. In some embodiments, the first sensor device is further configured for determining pairwise magnetic field differences ΔBx and ΔBy between parallel components. It is an advantage that these pairwise differences are less sensitive to external magnetic fields.

**FIG. 4B** shows a variant of FIG. 4A, having a sensor device 404b comprising one or more semiconductor substrates oriented parallel to the Z-direction, and in this example also parallel to the X-axis. In this embodiment, the sensor device 404b is preferably configured to measure one or more "in-plane" magnetic field components Bx parallel to the X-axis, and one or more "out-of-plane" magnetic field components By perpendicular to the semiconductor substrate(s), in one or more sensor locations, and optionally further configured for determining magnetic field differences between parallel components. Everything else mentioned for FIG. 4A is also applicable here, mutatis mutandis.

FIG. 4A and FIG. 4B may be jointly referred to as **FIG. 4****.**

In the examples shown in FIG. 4A and FIG. 4B, two surface-mount packages with eight-pins are shown, but of course the present invention is not limited hereto, and other packages with less than eight or more than eight pins can also be used, and of course in practice the package may be soldered on a printed circuit board, not explicitly shown, but which in FIG. 4A may be parallel to the XY plane, and which in FIG. 4B may be parallel to the XZ plane.

**FIG. 5A** shows an illustrative example of a sensor system 501a similar to the one of FIG. 4A or FIG. 4B, in cross-section, in a plane parallel to the XY plane, but instead of showing a single sensor device, it shows a single sensor location S1 where two orthogonal magnetic field components Bx, By are measured. If the sensor S1 is situated exactly in the centre of the virtual circle passing through the centrelines cA, cB, cC, the measured magnetic field components Bx, By will describe a circle, and the norm (or magnitude) of the combined magnetic field vector can be calculated as: $\left|B\right| = sqrt \left[sqr\left(Bx\right)+sqr\left(By\right)\right]$ [1] where sqrt is the squareroot function, and sqr is the square function, and the angle of the combined magnetic field vector can be calculated as: $ϕ = arctan \left(By/Bx\right)$ [2] where arctan is the arctangent function.

In a variant (not shown) of FIG. 5A, the sensor S1 is not located exactly in the middle of the virtual circle, but is located inside the virtual triangle formed by the intersections of the centrelines cA, cB, cC with the plane XY (also referred to herein as "centrepoints"). If not located exactly in the centre, the sensor S1 is preferably located on one of the perpendicular bisectors of the virtual triangle. As described above, in this case the magnetic field components Bx, By will not yield a perfect circle, but will yield a curve that is an ellipse or that very much resembles an ellipse. The norm |B| and the angle ϕ of the magnetic field seen by the rotor can also be derived from these "elliptical" values Bx, By, e.g. by applying a transformation that converts these "elliptical values" into "circular values", e.g. by performing the technique(s) described in FIG. 11, or by using a look-up table with interpolation, or in any other suitable way. Tests have shown that the formulas of FIG. 11 can also be used if the shape is not a perfect ellipse.

Referring back to FIG. 5A, as an example only, the electrical conductor portions may have a square cross-section of 3 mm x 3 mm, and the sides of the virtual triangle interconnecting the centrelines cA, cB, cC may be 6 mm long, but of course the present invention is not limited hereto, and electrical conductor portions having other cross-sectional shapes (e.g. circular shape) and/or other dimensions, spaced apart at other distances, can also be used.

When the sensor system 501a of FIG. 5A is used in the motor control system 110 of FIG. 1, the currents la, Ib, Ic can be derived from the values Bx, By using e.g. an inverse Park transformation.

When the sensor system 501a of FIG. 5A is used in the motor control systems 210 of FIG. 2 or 310 of FIG. 3, the rotor position ϕrot can be received from the position sensor 205, 305, and one or more of the values dϕ, Id, Iq can be derived from the values Bx, By and ϕrot.

In the example of FIG. 5A the busbar portions are slightly rotated relative to one another, such that the busbar portion structure is rotation symmetric with a periodicity of 120°. While this may provide an improved accuracy, such rotation is not absolutely required, especially if the distance between the sensor location and the busbar portions increases.

In a variant of FIG. 5A the busbar portions are rectangular and are oriented such that one side of the rectangular cross-section is parallel to the X-axis and the other is parallel with the Y-axis.

**FIG. 5B** shows a variant of FIG. 5A, where centrelines cA, cB, cC of the three parallel conductor portions A, B, C intersect the plane XY in three points (referred to herein as "centrepoints") situated at the corners of an isosceles but not an equilateral triangle, and wherein the sensor location S1 is situated outside of the virtual triangle defined by these "centrepoints". The magnetic sensor S1 of FIG. 5B is preferably located on a bisector of the line segments [cA,cC] and [cC, cB], at equal distances from the centrelines cA, cB, cC. The magnetic field components (Bx, By) measured in this location describe an ellipse, which can be transformed into a circle, e.g. using the technique(s) described in FIG. 11, or using a look-up table optionally with interpolation.

In a variant of FIG. 5B the sensor S1 may be located in another point, preferably also on the perpendicular bisector of the line segment cA-cB, for example having a first distance dA to centreline cA equal to a second distance dB to centreline cB, but having a distance dB to the centreline cB different from dA, for example a value in the range from about 25% to 250% of dA. The components Bx, By measured in this location may or may not describe a perfect ellipse, but can also be converted to a magnitude and a phase of the first vector, e.g. using the formulas of FIG. 11, or e.g. using a lookup-table with interpolation. The values of this lookup-table can be determined by simulation, or can be measured during a calibration procedure, or in any other suitable way, and may be stored in/retrieved from a non-volatile memory of the first sensor device.

It is noted that the invention will also work if the sensor location S1 is not located on the perpendicular bisector of the line segment cA-cB, but at a pseudo-random location at which the distances to the three centrelines are different from each other. As mentioned above, the resulting curve described by the components Bx, By may no longer be a perfect ellipse, but also in this case the formulas of FIG. 11 can be used as a good approximation, or alternatively a lookup-table with/without interpolation can be used.

In a variant (not shown) of FIG. 5B, the centrepoints of the three conductor portions A, B, C are not located at the corners of an isosceles triangle, but define a random triangle with three different angles. The principles described above can also be used in this case, but the results may become somewhat less accurate, and/or may become more sensitive to mounting offset.

**FIG. 5C** shows another variant of FIG. 5A and FIG. 5B, where centrelines cA, cB, cC of the three parallel conductor portions A, B, C are located in a plane XZ, and are preferably spaced apart equidistantly, and wherein the magnetic sensor is configured to measure two orthogonal magnetic field components Bx, By at a sensor location S1 situated outside of said plane, e.g. at a predefined distance above or below the plane XZ, preferably at a location at which the distances to the centrelines cA and cB are equal. At this location, the magnetic field components Bx, By will describe an ellipse or a shape very similar to an ellipse, which can be transformed into a circle, e.g. using the technique shown in FIG. 11, or using a look-up table.

It is an advantage that the busbar portions A, B, C can be arranged next to each other in a plane, because such arrangement may be much easier and/or more convenient to mount in a housing. It is also an advantage a (e.g. relatively large) printed circuit board (PCB) can be arranged parallel to the three busbar portions, and that the sensor device comprising the sensor S1 can be mounted on top of, or on the bottom side of this PCB (facing the conductor portions).

In a variant (not shown) of FIG. 5C, the centrelines cA, cB, cC are also located in a virtual plane, but are not spaced apart equidistantly and/or the sensor S1 is not located at equal distances from the centrelines cA and cB. The magnetic field components Bx, By of such an arrangement may not describe a perfect ellipse, but even in this case each point of the curve formed by Bx, By can be translated using a one-to-one translation (e.g. using mathematical formulas or using a lookup-table) to a point on the circle that corresponds with the combined magnetic field seen by the rotor of the motor when the same currents la, Ib, Ic are flowing through its stator coils.

FIG. 5A to FIG. 5C may be jointly referred to as **FIG. 5****.**

**FIG. 6A** shows a sensor system 601a which can also be used in the motor control systems of FIG. 1 to FIG. 3. The sensor system 601a of FIG. 6A can be seen a variant of FIG. 5A, wherein the sensor device (not explicitly shown, but the sensor locations S1, S2 thereof are shown) is configured to measure a set of two orthogonal magnetic field components in each of said two sensor locations, namely (Bx1,By1) in S1 and (Bx2,By2) in S2. The sensor device is further configured to determine two pairwise differences ΔBx=(Bx2-Bx1) and ΔBy=(By2-By1).

Preferably the sensor locations S1, S2 are located symmetrically about the centre of the virtual circle passing through the centrepoints cA, cB, cC. It was surprisingly found that the pairwise differences ΔBx, ΔBy measured at these locations describe an ellipse, or a curve very close to an ellipse, which as described above, can be converted into a circle using e.g. the technique(s) of FIG. 11, or using a look-up table, or in any other suitable way.

As an example only, the electrical conductor portions A, B, C may have a square cross-section of 3 mm x 3 mm, and the sides of the virtual triangle formed by the centrepoints may be 6 mm long, and the distance "dx" between the two sensor locations may be a value in the range from about 1.0 to about 3.0 mm, or in the range from 2.0 mm to 3.0 mm, e.g. equal to about 2.5 mm, but of course the present invention is not limited hereto, and other conductor arrangements can also be used.

In a variant (not shown) of FIG. 6A, the centrepoints of the centrelines cA, cB, cC are also located on an equilateral triangle, but the sensor locations S1, S2 are not located symmetrically with respect to the centre of this triangle. The magnetic field differences ΔBx, ΔBy of such an arrangement may not describe a perfect ellipse, but even in this case each point of the curve formed by ΔBx, ΔBy can be translated using a one-to-one relation (e.g. using mathematical formulas or using a lookup-table) to a point on the circle that corresponds with the combined magnetic field seen by the rotor of the motor when the same currents la, Ib, Ic are flowing through its stator coils.

**FIG. 6B** shows a sensor system 601b which can be seen as a variant of FIG. 5B having the same arrangement of conductor portions, but having two sensor locations S1, S2 instead of only one. FIG. 6B can also be see as a variant of FIG. 6A having the same sensors but a different arrangement of the electrical conductor portions.

Preferably the sensors S1, S2 are located on opposite sides of the symmetry plane SP that passes through the conductor portion C, in which case the values of ΔBx, ΔBy will describe an ellipse or a curve very close to an ellipse. Preferably the virtual point in the middle between S1 and S2 is situated at equal distances from the centrelines cA, cB, cC, but that is not absolutely required. The pairwise differences ΔBx, ΔBy measured in this location may or may not describe a perfect ellipse, but can also be converted to a magnitude |B| and a phase ϕ of the combined magnetic field experienced by the rotor, e.g. using a lookup-table with or without interpolation. The values of this lookup-table can be determined by simulation, or can be measured during a calibration procedure, or in any other suitable way, and may be stored in/retrieved from a non-volatile memory of the first sensor device.

Everything else described for FIG. 5B and its variants, is also applicable here, mutatis mutandis. For example, the invention will also work if the centrepoints of the conductor portions do not form an isosceles triangle and/or if the sensor locations S1, S2 are not situated in a symmetry plane, but the results may become somewhat less accurate, and/or may become more sensitive to mounting offset.

**FIG. 6C** shows a sensor system 601c which can be seen as another variant of FIG. 6A and FIG. 6B, where centrelines cA, cB, cC of the three parallel conductor portions A, B, C are located in a plane XZ, and are preferably spaced apart equidistantly. The sensor system 601c of FIG. 6C can also be seen as a variant of the sensor system 501c of FIG. 5C having the same conductor portions, but having two sensors S1 and S2, each configured for measuring two orthogonal magnetic field components.

The conductor portions A, B, C are preferably spaced apart equidistantly, and the sensors S1, S2 are preferably located on opposite sides of a symmetry plane SP passing through the centreline sC, at a predefined distance above the virtual plane passing through the centrelines cA, cB, cC, in which case the pairwise difference values ΔBx, ΔBy will describe an ellipse or a curve very close to an ellipse, which can easily be converted into a circle using the technique(s) of FIG. 11 before determining a magnitude |B| and a phase ϕ. But even if the conductor portions A, B, C are not spaced apart equidistantly and/or if the sensors S1, S2 are not located on opposite sides of said symmetry plane, the pairwise difference values ΔBx, ΔBy will describe a curve that looks like an ellipse, and that can also be converted into a circle by remapping each point of said curve using a one-to-one relation.

Everything else described for FIG. 5C and its variants, is also applicable here, mutatis mutandis.

**FIG. 6D** shows a variant of FIG. 6A, where the sides of the cross sectional areas of the three conductor portions are parallel to the X-axis and Y-axis, and where the triangle formed by the three centrelines cA, cB, cB is not an equilateral triangle, but is an isosceles triangle, where the distance dAC between the centrelines cA and cC is equal to the distance dBC between the centrelines cB and cC, but both are smaller than the distance dAB between the centrelines cA and cB. Compared to FIG. 6A, one could say that the position of the two sensors S1 and S2 has remained the same, but the conductor C is moved slightly upwards over a distance dy. Simulations (with area of conductor=3x3 mm, dAB=7 mm, dx=2.5 mm, dy=0.5 mm) have surprisingly shown that by doing so, the values ΔBx and ΔBy no longer describe an ellipse, but are located on a circle, or a quasi-circle. It is an advantage of this embodiment that no transformation (see e.g. FIG. 11) is required, but only a scaling operation to convert the ΔBx and ΔBy values from mTesla to Ampères. Although not explicitly shown, it is expected that, for a given cross-section of the conductors, and for a given distance dx between the two sensors S1, S2, and for a given distance dAB between the centrelines of the conductor portions A and B, and for a given position of the sensors S1 and S2 on a centre line between cA and cB perpendicular to [cA-cB], that a position can be found for the centreline cC where the graph formed by ΔBx and ΔBy shows a smallest deviation from a circle, such that the norm and the angle can be readily calculated using the formulas [11C] and [11D] of FIG. 11, without having to perform a shift, a rotation or a stretching, but only a scaling operation. The skilled person can easily find this optimal position by trial and error.

FIG. 6A to FIG. 6D may be jointly referred to as **FIG. 6****.**

**FIG. 7A** shows a sensor system 701a which can also be used in the motor control systems of FIG. 1 to FIG. 3. The sensor system 701a of FIG. 7A can be seen as a variant of FIG. 5A and FIG. 6A comprising three electrical conductor portions A, B, C having centrelines cA, cB, cC intersecting with a plane XY in centrepoints cA, cB, cC which are situated on a virtual circle angularly spaced apart by multiples of 120°, and wherein the sensor device 704a is configured to measure two orthogonal magnetic field components (Bx, By) in each of three sensor locations S1, S2, S3, and to calculate pairwise differences between parallel components, and to derive one or more of the output signals described in FIG. 1 to FIG. 3 based on these pairwise differences, optionally taking into account the actual rotor position ϕrot received from a second sensor device.

The first sensor device 704a of FIG. 7A is preferably oriented parallel to the plane XY and perpendicular to the direction Z in which the conductor portions A, B, C extend.

The three sensors S1, S2, S3 are preferably located on a second virtual circle which is concentric with the virtual circle comprising the centrepoints cA, cB, cC, and the sensor locations are preferably also angularly spaced by multiples of 120°. A ratio of the diameter of the second circle and the diameter of the first circle is preferably smaller than 50%, or smaller than 40%, or smaller than 30%. In the example shown, sensor S1 is located on a line segment passing through the virtual centre of the circle and the centrepoint cA, and S2 is located on a line segment passing through the virtual centre of the circle and cB, and S3 is located on a line segment passing through the virtual centre of the circle and the centrepoint cC, but that is not absolutely required.

The first or second sensor device can use various combinations of two magnetic field differences to determine the values Id, Iq, e.g. ΔBx12 and ΔBy12 at a first moment in time, and ΔBx23 and ΔBy23 at a second moment in time, e.g. depending on the actual rotor position, and/or depending on the orientation of the combined magnetic field. By dynamically choosing different pairs, the accuracy of the output signals may be increased. It is noted that different transformations (thus different sets of parameters and/or coefficients, or different look-up tables) may have to be used to convert the "elliptical values" into "circular values", depending on which combination is being used.

In a variant (not shown) of FIG. 7A the three sensors S1, S2, S3 are also located on a second circle but are not angularly spaced by multiples of 120°. In another variant (not shown) of FIG. 7A, the three sensors S1, S2, S3 are not located on a second circle, but are situated at three pseudo-random locations. The principles of the present invention also work in this case, as long as the three sensor locations are sufficiently spaced from each other and from the centrelines.

In the example shown in FIG. 7A, the conductor portions A, B, C have a square cross-section, but as mentioned above, that is not absolutely required, and other cross-sectional shapes can also be used, for example rectangular, circular, etc. In the example shown in FIG. 7A, the conductor portions are oriented in the same manner with their sides oriented parallel to the X and Y-direction, but that is not required either.

In a variant of FIG. 7A, the sensors S1, S2, S3 are also located on said second virtual circle, and are also angular spaced by multiples of 120°, but instead of calculating pairwise differences between two measured components, an average value of Bx is calculated as Bx_avg=(Bx1+Bx2+Bx3)/3 and an average value of By is calculated as By_avg=(By1+By2+By3)/3, and the pairwise differences may be calculated as:$ΔBx 1 _avg = \left(Bx1-Bx_avg\right) ; ΔBx 2 _avg = \left(Bx2-Bx_avg\right) ; ΔBx 3 _avg = \left(Bx3-Bx_avg\right) ;$$ΔBy 1 _avg = \left(By1-By_avg\right) ; ΔBy 2 _avg = \left(By2-By_avg\right) ; ΔBy 3 _avg = \left(By3-By_avg\right) ;$ and the output value (e.g. one or more of la, Ib, Ic, Iα,Iβ, |I|, |B|, ϕ, Id, Iq) is derived based on two of these differences (e.g. ΔBx1_avg and ΔBy1_avg at a first moment in time; e.g. ΔBx2_avg and ΔBy2_avg at a second moment in time; ΔBx3_avg and ΔBy3_avg at a third moment in time), optionally taking into account the actual rotor position ϕrot and/or the orientation of the combined magnetic field seen by the rotor.

**FIG. 7B** shows a sensor system 701b which can be seen as a variant of the sensor system 701a of FIG. 7A, where the electrical conductor portions A, B, C are rotated around their centrelines, such that they form a structure that is rotation symmetric with a periodicity of 120°. This may allow for a more compact arrangement and/or may provide an improved accuracy for the output signal(s). Everything else described for FIG. 7A and the variants thereof, is also applicable here.

**FIG. 7C** shows a sensor system 701c which can be seen as a variant of FIG. 5B or FIG. 6B having the same conductor portion arrangement but having three magnetic sensors S1, S2, S3 instead of only one or only two. Preferably each magnetic sensor is configured to measure a set of two orthogonal magnetic field components (Bx, By). The three sensor locations of FIG. 7C are situated on a virtual line parallel to the X-axis. The semiconductor substrate of the sensor device (not explicitly shown) comprising these sensors S1, S2, S3 may be arranged parallel to the XY plane (as in FIG. 4A) or parallel to the XZ plane (as in FIG. 4B). In an embodiment, the three sensors S1, S2, S3 are located inside the virtual triangle formed by the intersection points cA, cB, cC. In another embodiment, the three sensors S1, S2, S3 are located on the virtual line segment passing through the centrepoints cA and cB. In yet another embodiment, the three sensors S1, S2, S3 are located outside of the virtual triangle. The magnetic field differences mentioned in FIG. 7A, or the magnetic field differences obtained by subtraction of Bx_avg or By_avg described above, can be used. The output signal(s) can be based on two of these differences, optionally taking into account the actual rotor position ϕrot. Different pairs may be combined during different moments in time, e.g. depending on the actual rotor position and/or the actual orientation of the combined magnetic field.

In the example shown in FIG. 7C, the sensors S1, S2, S3 are located on a line parallel to the X-direction, and are equidistant from each other, and the sensor S2 is situated in a symmetry plane between centreline cA and cB, but that is not absolutely required, and the invention will also work if the three sensors are not located on a line parallel to X, and/or if the distance between S1 and S2 is not equal to the distance between S2 and S3 and/or if the sensor S2 is not situated in said symmetry plane.

**FIG. 7D** shows a sensor system 701d which can be seen as a variant of the sensor system 701c of FIG. 7C, wherein the three sensor locations S1, S2, S3 are also situated in the virtual plane XY, but are not situated on a virtual line parallel to the X-axis. In an embodiment, the three sensors are located inside the virtual triangle. In another embodiment, two of the sensors S1, S3 are located outside of the virtual triangle and one sensor S2 is located inside the virtual triangle. In yet another embodiment, the three sensors are located outside of the virtual triangle. Everything else mentioned for FIG. 7C and its variants is also applicable here.

**FIG. 7E** shows a sensor system 701e which can be seen as a variant of the sensor systems of FIG. 5C and FIG. 6C having the same conductor portion arrangement, but having three magnetic sensors S1, S2, S3 instead of only one or only two sensors. The sensor system of FIG. 7E can also be seen as a variant of FIG. 7C where the three conductor portions are situated in a virtual plane, and thus also as a further variant of FIG. 7A.

Preferably each magnetic sensor is configured to measure two orthogonal magnetic field components (Bx, By). The three sensor locations of FIG. 7E are preferably situated on a virtual line parallel to the X-axis, and are preferably spaced apart equidistantly, and the sensor S2 is preferably located in a symmetry plane between cA and cB. The sensor device (not explicitly shown) comprising these sensors may be arranged parallel to the XY plane (as in FIG. 4A) or parallel to the XZ plane (as in FIG. 4B). Everything else described above is also applicable here, mutatis mutandis.

**FIG. 7F** shows a sensor system 701f which can be seen as a variant of the sensor system 701e of FIG. 7E, wherein the three sensor locations are also situated in the virtual plane XY, but are not situated on a virtual line parallel to the X-axis. The first sensor device (not explicitly shown) comprising these sensors is preferably oriented parallel to the XY plane (as in FIG. 4A).

**FIG. 7G** shows a sensor system 701g which can be seen as a variant of the sensor system 701a, where the sensors S1, S2, S3 are configured to measure magnetic field components in a predefined direction (in the example shown: in the X-direction), and where the sensor device is further configured to determine at least two magnetic field differences between these three components. In FIG. 7G three pairwise differences are shown, but two pairwise differences are sufficient at any moment in time. Everything else described above is also applicable here, mutatis mutandis, for example, it is possible to use different pairwise differences are various moments in time, e.g. dependent on the angular position of the rotor, and/or dependent on the angular position of the combined magnetic field.

In the example of FIG. 7G, three Bx components are measured, but the present invention is not limited thereto, and the three components measured can be oriented in another direction in the XY-plane, for example three components (By1, By2, By3) oriented in the Y-direction.

In a variant (not shown) of FIG. 7G, the conductor portions A,B,C are not arranged on an equilateral triangle but on an isosceles triangle, and the sensors S1, S2, S3 are arranged as illustrated in FIG. 7C or FIG. 7D, but are 1D magnetic pixels configured for measuring magnetic field components Bx1, Bx2, Bx3 oriented in the X-direction. The formulas of FIG. 7G are also applicable.

**FIG. 7H** shows a sensor system 701h which can be seen as a variant of the sensor system 701e of FIG. 7E, and/or as a variant of the sensor system of FIG. 7G. In the system of FIG. 7H, the centrelines cA, cB, cC of the conductor portions are located in a virtual plane, and the sensors S1, S2, S3 are configured to measure three magnetic field components Bx1, Bx2, Bx3 oriented in the X-direction, and the sensor device is configured for determining at least two magnetic field differences between these values. The formulas of FIG. 7G are applicable.

**FIG. 7I** shows a sensor system 701i which can be seen as a variant of the sensor system 701h of FIG. 7H, and/or as a further variant of FIG. 7G, where three magnetic field components are measured in the Y-direction instead of the X-direction.

**FIG. 7J** shows a sensor system 701j which can be seen as yet another variant of FIG. 7A, where the conductor portions A, B, C are arranged on an equilateral triangle, and where the sensor device has four sensor locations S1 to S4 arranged on a virtual circle which is concentric with the circle passing through the centrelines cA, cB, cC. Two of these sensors S1, S2 are configured for measuring Bx components oriented in the X-direction. The other two sensors S3, S4 are configured for measuring By components oriented in the Y-direction. The sensor device is further configured for determining two pairwise differences ΔBx, ΔBy, from which values many other values can be derived, optionally including the rotation angle ϕrot. Everything else mentioned above for FIG. 7A is also applicable here. For example, the invention will also work if the sensors are not exactly located symmetrically about the centre of the virtual circle passing through the centre points.

In an embodiment, the three sensors S1, S2, S3 are three horizontal Hall elements (without IMC) integrated on a single semiconductor substrate.

**FIG. 7K** shows a sensor system 701k which can be seen as a variant of FIG. 7J, comprising four 2D pixels S1 to S4 located at the same locations as illustrated in FIG. 7J. S1 measures (Bx1,By1). S2 measures "Bx2,By2). S3 measures "Bx3,By3). S4 measures "Bx4,By4). A first set of two pairwise differences can be calculated as follows: ΔBx12=(Bx2-Bx1); ΔBy12=(By2-By1). A second set of two pairwise difference signals can be calculated as follows: ΔBy12=(By2-By1); ΔBx12=(Bx2-Bx1). The second set can be used for error detection.

FIG. 7A to FIG. 7K may be jointly referred to as **FIG. 7****.**

It is noted that the first sensor device itself (preferably a single chip) is not shown in FIG. 5A to FIG. 7F and in FIG. 7H and FIG. 7I for illustrative purposes, but the sensor locations are shown. As mentioned above, the first sensor device may comprise at least one semiconductor substrate comprising said one or more magnetic sensor(s), and other circuitry, e.g. as will be described further (see e.g. FIG. 14 or FIG. 15).

**FIG. 8A** shows an illustrative example of an arrangement 802 comprising three conductor portions A, B, C having rectangular cross-sections, as can also be used in the sensor system of FIG. 4A, FIG. 4B, FIG. 5A, FIG. 6A, FIG. 7A, FIG. 7B, and illustrating that the cross-sections of the busbar portions do not need to be square, nor do they need to be rotated relative to one another to form a rotation symmetric structure.

**FIG. 8B** shows an illustrative example of another arrangement 803 comprising three conductor portions A, B, C having rectangular cross-sections, as can also be used in the sensor system of FIG. 5C, FIG. 6C, FIG. 7E and FIG. 7F, illustrating that the cross-sections of the busbar portions do not need to be square.

In a variant (not shown) of FIG. 8B, the rectangular cross-sections are oriented "upright", i.e. with the long side of the rectangular cross-section oriented in the Y-direction, and the short side oriented in the X-direction.

As mentioned above, the present invention is not limited to sensor systems having electrical conductor portions with square or rectangular cross-sections, and the invention will also work with conductor portions having other cross-sections (e.g. circular).

FIG. 8A and FIG. 8B may be jointly referred to as **FIG. 8****.**

**FIG. 9** shows a sensor system 901 which can also be used in the motor control systems of FIG. 1 to FIG. 3. The sensor system 901 can be seen as yet another variant of FIG. 4A and FIG. 4B that comprises: three electrical conductor portions A, B, C crossing each other, and a magnetic sensor S1 arranged in the vicinity of the conductor portions, and capable of measuring three orthogonal magnetic field components (Bx, By, Bz) at a single location. The sensor device 904 of FIG. 9 may be mounted on a printed circuit board 920, which may be mounted parallel to two conductor portions A, C.

The same principles as described above can be used to convert the measured magnetic field components into currents la, Ib, Ic, and/or to derive information (e.g. amplitude and phase, or angular speed) about the magnetic field vector generated by those currents as would be seen by the rotor of the motor.

Each of the signal pairs (Bx,By), (Bx,Bz), (By,Bz) can be plotted as a 2D curve, and these curves may look like an ellipse, in which case the transformation of FIG. 11 can be used to convert the "elliptical values" into "circular values" from which the amplitude |B| and phase ϕ of the combined magnetic field can be derived, which values can then be used to calculate and optionally output other values, such as Δϕ, Id, Iq. In case the curve described by any of these pairs does not resemble an ellipse, a look-up table can be used instead. It is again possible to consider a particular pair e.g. (Bx,By) only during a portion of a cycle, and the other pair(s) during another portion of the cycle. Each signal pair may describe another ellipse or another shape, and the "elliptical values" for each pair may be converted to "circular values" using different transformations, e.g. using different values of a, Gx, Gy in FIG. 11, or using three different look-up tables. Which pair is used at a particular time may depend on the actual rotor position and/or on the orientation of the combined magnetic field seen by the rotor. By doing so, the accuracy (e.g. resolution) may be improved.

In some embodiments, the sensor device 904 may be furthermore communicatively connected to a position sensor 305 (e.g. as illustrated in FIG. 3) and configured to receive an angular position ϕrot of the rotor, and configured to determine and optionally output one or more of the following signals: Δϕ=(ϕ-ϕrot), or currents (Id, Iq) in the "qd" frame that rotates along with the rotor of the motor that is powered by the same currents la, Ib, Ic which are flowing through the electrical conductor portions.

In a variant (not shown) of FIG. 9, the sensor system comprises two parallel conductor portions, and one conductor portion that crosses the other two.

**FIG. 10** shows a sensor system 1001 which can also be used in the motor control systems of FIG. 1 to FIG. 3. The sensor system 1001 can be seen as a variant of the sensor systems shown in FIG. 6A to FIG. 6C, wherein the electrical conductor portions A, B, C are not parallel, but are crossing each other. The sensor system 1001 can also be seen as a variant of the sensor system of FIG. 9, wherein three magnetic field components are measured at two locations, and where two or three gradients are determined.

In the example shown in FIG. 10, the sensor system 1001 comprises two sensors S1, S2, each capable of measuring three orthogonal magnetic field components (Bx, By, Bz). The sensor device 1004 is furthermore capable of determining three magnetic field differences ΔBx, ΔBy, ΔBz. The sensor device 1004 may furthermore be connected to a position sensor 305 (as illustrated in FIG. 3), for exchanging information between the first and the second sensor device, e.g. as illustrated in FIG. 3 or FIG. 15.

In some embodiments, the sensor device 1004 is furthermore configured to receive an angular position ϕrot of the rotor, and to determine and optionally output one or more of the following: Δϕ=(ϕ-ϕrot), or currents (Id, Iq) in the "qd" frame that rotates along with the rotor of the motor which is powered by the currents flowing through the electrical conductor portions.

The same principles as described above can be used to convert the magnetic field differences ΔBx, ΔBy, ΔBz into currents la, Ib, Ic, and/or to derive information (e.g. amplitude and phase, or angular speed) of the magnetic field vector generated by those currents as would be seen by the rotor of the motor. As explained above, the output signal(s) may be based on (ΔBx, ΔBy) during a first time period, and may be based on (ΔBx, ΔBz) during a second time period, and may optionally be based on (ΔBy, ΔBz) during a third time period.

In a variant (not shown) of FIG. 10, the sensor system comprises two parallel conductor portions, and one conductor portion that crosses the other two.

In another or further variant (not shown) of FIG. 10, the sensor device 1004 comprises three sensors S1, S2, S3, each capable of measuring two or three orthogonal magnetic field components (Bx, By, Bz). The additional measurements can be used for improving the accuracy (e.g. resolution) during certain portions of a cycle, and/or may be used for error detection purposes.

**FIG. 11** illustrate a technique in which a set of two corresponding values (e.g. two magnetic field components Bx,By, or two magnetic field differences ΔBx, ΔBy) describing an ellipse, or a curve that looks like an ellipse, e.g. a quasi-ellipse or a quasi-circle as defined above, can be converted into a set of values describing a circle, and how a magnitude |B| and a phase ϕ can be determined.

FIG. 11 shows a first (optional) step, wherein the ellipse can be shifted towards the centre using two offset-values X0, Y0; and a second (optional) step where the ellipse can be rotated (if needed) over an angle α, and shows a third (optional) step, wherein the ellipse can be stretched (if needed) in the X or Y-direction using a gain Gx and/or a gain Gy.

For any given sensor system described above, the values of X0,Y0,α, Gx, Gy may be determined by simulation or by performing a calibration test, and these values and/or values derived therefrom, e.g. cos(α) and sin(α), may be written in a non-volatile memory of the sensor device.

If the measured signals already describe a circle, or a quasi-circle, two offset values X0,Y0 can be used to translate the quasi-circle towards the centre, and a scaling factor G can be used to convert for example magnetic field values into current values.

As described above, the parameters or coefficients X0,Y0, α, Gx, Gy or X0,Y0,G or the like, will typically depend on the particular arrangement of the electrical conductor portions and on the position and orientation of the magnetic field components or difference which are measured. For a given arrangement and for each given pair of signals, the parameters or coefficients are fixed, and may be determined by simulation and/or by performing a calibration procedure, and may be stored in a non-volatile memory of the sensor system (e.g. inside the first sensor device or inside the second sensor device).

As also described above, it is also possible to use other transformations to convert the "elliptical values" into "circular values", e.g. by using a look-up table with or without interpolation. The values of the look-up table will typically depend on the particular arrangement of the electrical conductor portions and on the position and orientation of the magnetic field components or difference which are measured.

**FIG. 12** shows a flow-chart of a method 1200 of controlling an electrical motor having a plurality of stator windings and a rotor. The method comprises the following steps:
a) optionally providing in step 1201 a plurality of electrical conductor portions (A, B, C) for conducting a plurality of electrical currents (e.g. la, Ib, Ic), which together form a combined magnetic field, and providing a first sensor device (e.g. 104, 204, 304, 404a, 404b, 704a, 904, 1004, 1404, 1504) comprising a plurality of magnetic sensors (e.g. S1; S1,S2; S1,S2,S3). The electrical conductor portions A, B, C may be electrically connected in series or anti-series with respective stator windings;
x) optionally providing in step 1202 a second sensor device (e.g. 106, 206, 306, 1506) communicatively connected to the first sensor device, the second sensor device being configured for determining an actual angular position (ϕrot) of the rotor. The second sensor device may be part of an inductive position sensor system 105, 205, 305, e.g. as illustrated in FIG. 1 to FIG. 3. The inductive position sensor system may comprise a printed circuit board with a plurality of coils, and a so called target which is connected to the rotor of the motor. But the present invention is not limited to this type of position sensor, and other types of position sensor can also be used;
b) measuring in step 1203, by the first sensor device, at least two magnetic field components (e.g. Bx, By) or at least two magnetic field differences (e.g. ΔBx, ΔBy) or at least two magnetic field gradients of the combined magnetic field generated by the currents flowing through the conductor portions A, B, C, in one or more sensor locations. The first sensor device is located in the vicinity of the electrical conductor portions A, B, C;
y) optionally transforming in step 1204, by the first sensor device, the measured magnetic field components or magnetic field differences or magnetic field gradients, (e.g. from what is described above as a transformation from so called "elliptical values" to "circular values" for the sake of understanding, but as explained above, an elliptical shape is not absolutely required), e.g. by performing a rotation operation and/or a stretching operation using mathematical formulas with predefined parameters or coefficients (e.g. α, Gx, Gy), or by using a look-up table with or without interpolation. These parameters and/or coefficients and/or values of the lookup-table may be different for each pair of corresponding values, e.g. for each pair of magnetic field components, or for each pair of magnetic field differences. In this way, the transformed values represent a vector that describes a circle, and the amplitude |B| and phase ϕ of this vector can be calculated;
c) determining and/or outputting in step 1205, by the first or second sensor device, one or more of the following sets of signals:
   i) angular position (e.g. ϕrot measured by the second sensor device) and/or magnetic field components (e.g. Bx, By), magnetic field differences (e.g. ΔBx, ΔBy), or magnetic field gradients, e.g. measured or determined by the first sensor device;
   ii) two or more signals (e.g. Ia,Ib,Ic, Iα,Iβ, |I|) indicative of (e.g. proportional to) the electrical currents (e.g. la, Ib, Ic) flowing in said electrical conductor portions (e.g. A, B, C);
   iii) one or more signals (e.g. Bx,By; |B|, ϕ) indicative of (e.g. proportional to) a first field vector (v1) of the combined magnetic field generated by the currents (la, Ib, Ic) flowing through the electrical conductor portions and flowing through the motor coils, and/or one or more signals (dB/dt, dϕ/dt, Δϕ; Id,lq) derived therefrom, optionally taking into account the rotor position (ϕrot);

It is noted that step y) may be replaced by a simple scaling operation if the measured component values or gradient values already describe a circle. The scaling factor to be used can also be determined by performing a simulation or during a calibration procedure, and may be stored in, and retrieved from a non-volatile memory.

**FIG. 13** shows another flow-chart of a method 1300 of controlling an electrical motor. The steps a), x), b), and y) are identical to those of FIG. 12, but step c) is formulated slightly different. The method 1300 comprises the following steps:
a) optionally providing in step 1301 a plurality of electrical conductor portions (e.g. A, B, C) for conducting a plurality of electrical currents, which together form a combined magnetic field, and providing a first sensor device comprising a plurality of magnetic sensors;
x) optionally providing in step 1302 a second sensor device communicatively connected to the first sensor device, the second sensor device being configured for determining an actual angular position (ϕrot) of a rotor;
b) measuring in step 1303, by the first sensor device, at least two magnetic field components or at least two magnetic field differences or at least two magnetic field gradients of the combined magnetic field generated by the currents (la, Ib, Ic) flowing through the electrical conductor portions (e.g. A, B, C), in one or more sensor locations;
y) optionally transforming in step 1304, by the first sensor device, the measured magnetic field components or magnetic field differences or magnetic field gradients, e.g. by performing a rotation operation and/or a stretching operation using mathematical formulas with predefined parameters or coefficients (e.g. α, Gx, Gy), or by using a look-up table with or without interpolation;
c) performing by the first or second sensor device at least one of the following:
   c1) outputting in step 1306 one or more of the measured angular position (ϕrot) and/or measured or determined magnetic field components, magnetic field differences, magnetic field gradients;
   c2) calculating and/or outputting in step 1307 two or more signals (e.g. la,lb,lc, Iα,Iβ, |I|) indicative of (e.g. proportional to) the electrical currents (e.g. la, Ib, Ic) flowing in said electrical conductor portions (e.g. A, B, C);
   c3) calculating and/or outputting in step 1308 one or more signals (e.g. Bx,By; |B|,ϕ) indicative of (e.g. proportional to) a field vector (v1) of the combined magnetic field generated by the currents flowing through the electrical conductor portions (e.g. A, B, C) and flowing through the motor coils, and/or one or more signals (dB/dt, dϕ/dt, Δϕ; Id,lq) derived therefrom, optionally taking into account the rotor position (ϕrot);
   c4) calculating and/or outputting in step 1309 current values (Id, Iq) in a rotor reference frame (also referred to as "dq-frame"), based on the measured magnetic field values and on the rotor position (e.g. ϕrot).

**FIG. 14** shows an illustrative example of a block-diagram of a "first sensor device" 1404 as can be used in embodiments of the present invention, e.g. as the first sensor device in FIG. 1 to FIG. 10. The block-diagram of FIG. 14 is provide for completeness.

The first sensor device 1404 of FIG. 14 comprises at least one semiconductor substrate comprising a plurality of magnetic sensor elements M1, M2, etc.

The sensor device 1404 may comprise for example 2D magnetic pixels, each comprising at least two vertical Hall elements oriented in perpendicular directions; or 2D pixels comprising at least two horizontal elements arranged near the periphery of an integrated magnetic concentrator (IMC) disk and spaced apart by 180°; or may comprise for example 3D magnetic pixels, each comprising at least one horizontal Hall element and two vertical Hall elements oriented in perpendicular directions; or 3D pixels comprising at least four horizontal Hall elements arranged near the periphery of an integrated magnetic concentrator (IMC) disk and spaced apart by multiples of 90°, but the present invention is not limited hereto, and other magnetic sensors may also be used, e.g. magneto-resistive sensors, e.g. AMR, GMR, XMR, TMR sensors.

The sensor device 1404 further comprises a biasing and readout circuit 1422 for biasing the magnetic sensor elements. Biasing and read-out circuits are well known in the art, are not the main focus of the present invention, and hence do not need to be described in more detail here. It suffices to say that the biasing and readout circuit may comprise for example one or more current sources or voltage sources, one or more amplifiers, one or more multiplexer, one or more analog-to-digital convertors (ADC), etc.

The sensor device 1404 typically also comprises at least one temperature sensor Temp, e.g. arranged for measuring or estimating a temperature of the magnetic sensor elements, e.g. a single temperature sensor configured to measure a temperature of the semiconductor substrate that contains the magnetic sensor elements.

The sensor device 1404 further comprises a processing circuit 1423, e.g. a digital processing circuit, e.g. comprising a programmable processor, e.g. a CPU or a Digital Signal Processor (DSP). The processing circuit may be implemented on the same semiconductor substrate that also comprises the magnetic sensors, but that is not absolutely required, and the processing circuit may also be implemented on a second semiconductor substrate, electrically connected to the first semiconductor substrate that comprises the magnetic sensors, but preferably integrated in the same packaged semiconductor device or "chip".

The sensor device 1404 may further comprise a non-volatile memory, e.g. flash, which may be incorporated in the processing circuit, or may be connected to the processing circuit, and which may store one or more parameters or coefficients, for example one or more sets of α, Gx, Gy described in FIG. 11, or values derived therefrom, e.g. cos(α) and sin(α), one or more look-up tables described above. But of course, the non-volatile memory may also contain other information, such as for example executable instructions.

The sensor device 1404 may further comprise a communication interface, e.g. a high speed uni-direction or bi-direction serial port, e.g. for receiving position values from a position sensor device (see e.g. FIG. 3), and/or for sending magnetic field component values or difference values to the second sensor device (e.g. in a variant of FIG. 3).

The sensor device 1404 may further comprise a buffer, e.g. for temporarily storing position values received from the position sensor device.

The sensor device 1404 may further comprise a timer, e.g. for adding timing information to the values stored in said buffer.

The sensor device 1404 may further comprise an output circuit and an output port, e.g. for providing output signals or values to another processor (e.g. to the current controller of FIG. 1 to FIG. 3) in a suitable format (e.g. a parallel or serial interface).

In preferred embodiments, the sensor device 1404 is a single packaged semiconductor device, typically referred to as "chip package".

The first sensor device 1404 is configured to perform the method of FIG. 12 or the method of FIG. 13.

It is noted that the sensor device 1404 may also determine and optionally output the time derivative of Id and Iq, i.e. d(Id)/dt and d(Iq)/dt.

**FIG. 15** shows an illustrative example of a block-diagram of a sensor system 1501 comprising a first sensor device 1504 and a second sensor device 1506 as can be used in embodiments of the present invention. This block-diagram can be used to implement the "variant of FIG. 3" described above.

FIG. 15 can be seen as a variant of FIG. 14, where more details are provided of a possible implementation of the second sensor device 1506, and where the first sensor device 1504 provides signals (e.g. one or more of Ia,Ib,Ic, Iα,Iβ, |I|, Bx,By, ΔBx,ΔBy, |B|,ϕ, dB/dt, dϕ/dt) to the second sensor device 1506, and where the second sensor device 1506 is configured to calculate Id, Iq signals, and is configured to output one or more of the signals la,lb,lc, Iα,Iβ, |I|, Bx,By, ΔBx,ΔBy, |B|,ϕ, dB/dt, dϕ/dt Δϕ,Id,Iq to the current controller block of FIG. 1 to FIG. 3.

It is noted that the sensor device 1506 may also determine and optionally output the time derivative of Id and Iq, i.e. d(Id)/dt and d(Iq)/dt.

The present invention is also related to a multiphase metering system (also referred to as a power consumption meter) comprising a sensor system as described above (see e.g. block 101 of FIG. 1, block 201 of FIG. 2, block 301 of FIG. 3, FIG 14). The sensor system comprises a plurality of electrical conductor portions and a plurality of magnetic sensors (e.g. arranged as illustrated in FIG. 4A to FIG. 10). The magnetic sensors are preferably integrated in a single semiconductor substrate, which may e.g. be comprised in a sensor device as depicted in FIG. 14. The multiphase metering system can of course comprise other components, such as e.g. a display, buttons, etc.

The present invention is related to an electrical power converter comprising a sensor system as described above (see e.g. block 101 of FIG. 1, block 201 of FIG. 2, block 301 of FIG. 3, FIG 14). The sensor system comprises a plurality of electrical conductor portions and a plurality of magnetic sensors (e.g. arranged as illustrated in FIG. 4A to FIG. 10). The magnetic sensors are preferably integrated in a single semiconductor substrate, which may e.g. be comprised in a sensor device as depicted in FIG. 14. The electrical power converter can of course comprise other components, such as e.g. a display, buttons, etc.

### References:

- -01: sensor system
- -02: busbar arrangement
- -03: busbar arrangement
- -04: first sensor device, (also "current sensor device")
- -05: position sensor (also "position sensor subsystem")
- -06: second sensor device, (also "position sensor device")
- -10: motor control system
- -11: processing block including a Clarke-Park transform
- -12: current controller
- -13: torque convertor
- -14: processing block including a Reverse Clarke-Park transform
- -20: printed circuit board
- -22: biasing and readout circuit
- -23: processing circuit
- S1, S2, ...: first, second, ... sensor or sensor location
- cA, cB, cC: centreline of conductor A,B,C
- A, B, C: first, second, third electrical conductor portion.
- ϕrot: angular position of a rotor; or phase of a voltage signal, etc.

## Claims

1. A sensor system (101; 201; 301; 1501) comprising:
- a plurality of electrical conductor portions (A, B, C) spaced apart from each other, and configured for conducting a plurality of electrical currents (la, Ib, Ic) of a multiphase current system, wherein each current will generate a respective magnetic field, which magnetic fields are superimposed to form a combined magnetic field;
- a first sensor device (104; 204; 304; 1404; 1504) comprising a plurality of magnetic sensors or a plurality of magnetic sensor elements, configured for measuring characteristics of the combined magnetic field;
wherein the first sensor device (104; 204; 304; 1404; 1504) is configured to measure at least two magnetic field components (Bx,By; Bx,By,Bz) or at least two magnetic field differences (ΔBx, ΔBy) or at least two magnetic field gradients of the combined magnetic field in one or more sensor locations (S1; S1,S2;S1,S2,S3);
and wherein the sensor system (101; 201; 301; 1501) is configured to perform at least one of the following:
a) to output one or more of the measured magnetic field components or magnetic field differences or magnetic field gradients;
b) calculate and/or output two or more signals (la,lb,lc, Iα,Iβ) indicative of (e.g. proportional to) the electrical currents (Ia,Ib,Ic) flowing in said electrical conductor portions (A,B,C);
c) calculate and/or output one or more signals (Bx,By; | B|,ϕ) indicative of (e.g. proportional to) a field vector (v1) of the combined magnetic field generated by the currents flowing through the electrical conductor portions, and/or one or more signals (dB/dt; dϕ/dt; Δϕ; Id,Iq) derived therefrom, based at least on said at least two magnetic field components or said at least two magnetic field differences or said at least two magnetic field gradients.

2. A sensor system (101; 201; 301; 1501) according to claim 1,
wherein the sensor system further comprises a second sensor device (106; 206; 306; 1506) communicatively connected to the first sensor device (104; 204; 304; 1504), the second sensor device being configured for determining an actual angular position (ϕrot);
and one or both of the following options:
i) wherein the first sensor device (104; 204; 304; 1504) is configured for receiving said actual angular position (ϕrot) from the second sensor device, and for determining an angular difference (Δϕ) between an angle (ϕ) of said vector (v1) of the combined magnetic field and the actual angular position (ϕrot), and for optionally outputting this angular difference (Δϕ);
ii) wherein the second sensor device (106; 206; 306; 1506) is configured for receiving one or more of said signals (la,lb,lc, Iα,Iβ, |I|, Bx,By, ΔBx, ΔBy, |B|,ϕ, dB/dt, dϕ/dt) from the first sensor device, and is further configured for determining an angular difference (Δϕ) between an angle (ϕ) of said combined magnetic field and an angle related to the actual angular position (ϕrot), and for optionally outputting at least this angular difference (Δϕ).

3. A sensor system (101; 201; 301; 1501) according to claim 2,
wherein one of the first sensor device (104; 204; 304; 1504) and the second sensor device (106; 206; 306; 1506) is further configured to convert the angular difference (Δϕ) into a set of currents (Id, Iq) in a rotor-reference-frame, and to output these current values.

4. A sensor system (101; 201; 301; 1501) according to any of the claims 1 to 3,
wherein the first sensor device (104; 204; 304; 1504) comprises at least two magnetic sensors (S1, S2) spaced apart from each other, each magnetic sensor configured for measuring at least two orthogonal magnetic field components (Bx1,By1; Bx2,By2);
and wherein the first sensor device (104; 204; 304; 1504) is configured for determining at least two magnetic field differences (ΔBx; ΔBy) or at least two magnetic field gradients based on pairwise differences of said magnetic field components, or based on a difference between a measured magnetic field component and an average component;
and wherein the first sensor device (104; 204; 304; 1504) is configured to determine and optionally output said one or more signals (la,lb,lc, Iα,Iβ, |I|, Bx,By, ΔBx, ΔBy, |B|,ϕ, dB/dt, dϕ/dt, Id, Iq) based on said at least two magnetic field differences or based on said at least two magnetic field gradients, and optionally also based on said rotor position (ϕrot).

5. A sensor system (101; 201; 301; 1501) according to any of the claims 1 to 3,
wherein the first sensor device (104; 204; 304; 1504) comprises at least three magnetic sensors (S1, S2, S3) spaced apart from each other, each magnetic sensor configured for measuring at least one magnetic field component oriented in a predefined direction (Bx1,Bx2,Bx3);
and wherein the first sensor device (104; 204; 304; 1504) is configured for determining at least two magnetic field differences (ΔBx12,ΔBx23) or at least two magnetic field gradients based on pairwise differences of said magnetic field components, or based on a difference between a measured magnetic field component and an average component;
and wherein the first sensor device (104; 204; 304; 1504) is configured to determine and optionally output said one or more signals (la,lb,lc, Iα,Iβ, |I|, ΔBx12, ΔBx23, |B|,ϕ, dB/dt, Δϕ,dϕ/dt, Id, Iq) based on said at least two magnetic field differences or based on said at least two magnetic field gradients, and optionally also based on said rotor position (ϕrot).

6. A sensor system (101; 201; 301; 1501) according to any of the claims 1 to 3,
wherein the first sensor device (104; 204; 304; 1504) comprises at least one magnetic sensor (S1) configured for measuring at least two orthogonal magnetic field components (Bx,By; Bx1,By1,Bz1) at a predefined location;
and wherein the first sensor device (104; 204; 304; 1504) is configured to determine and optionally output said one or more signals (la,lb,lc, Iα,Iβ, |I|, Bx,By, ΔBx, ΔBy, |B|,ϕ, dB/dt, dϕ/dt, Δϕ,Id, Iq) based on said at least two orthogonal magnetic field components.

7. A sensor system (101; 201; 301; 1501) according to claim 6,
wherein the first sensor device (104; 204; 304; 1504) comprises at least three magnetic sensors (S1, S2, S3) spaced apart from each other in one or two directions, each magnetic sensor being configured for measuring at least two (Bx,By), or at least three (Bx,By,Bz) orthogonal magnetic field components.

8. A sensor system (901) according to claim 6,
wherein the first sensor device (904) comprises a magnetic sensor (S1) configured for measuring three orthogonal magnetic field components (Bx1, By1, Bz1) at a predefined location.

9. A sensor system (101; 201; 301; 1501) according to any of the previous claims,
wherein the plurality of electrical conductor portions are part of two busbars having elongated portions extending in parallel in a first direction;
and/or wherein the plurality of electrical conductor portions are part of three busbars having elongated portions (A,B,C) extending in parallel in a first direction (Z), each elongated portion having a centreline (cA,cB,cC) that intersects with a virtual plane (XY) oriented perpendicular to the first direction (Z), and wherein the intersections define an equilateral triangle;
and/or wherein the plurality of electrical conductor portions are part of three busbars having elongated portions (A,B,C) extending in parallel in a first direction (Z), each elongated portion having a centreline (cA,cB,cC), wherein the centrelines are located in a single plane;
and/or wherein the plurality of electrical conductor portions are part of three busbars having elongated portions (A,B,C) extending in three crossing directions.

10. A sensor system (101; 201; 301; 1501) according to any of the previous claims,
wherein pairs of magnetic field components or pairs of magnetic field differences or pairs of magnetic field gradients are transformed by performing one or more of the following: a shift operation, a rotation operation, a stretching operation, a scaling operation before determining a norm and/or an angle (ϕ) of the vector ( v1) of the combined magnetic field;
or wherein pairs of magnetic field components or pairs of magnetic field differences or pairs of magnetic field gradients are transformed using a lookup-table with or without interpolation, before determining an angle (ϕ) of the vector( v1) of the combined magnetic field.

11. A motor control system (110; 210; 310) comprising:
- a sensor system (101; 201; 301; 1501) according to any of the previous claims;
- an electrical motor having a stator comprising a plurality of coils and having a rotor;
wherein the coils of the motor are electrically connected in series with at least some of the electrical conductor portions (A,B,C) of the sensor system;
optionally further comprising a current controller (112; 212; 312) and a processing circuit (114; 214; 314) configured to perform at least a Reverse Clarke-Park transform;
and optionally further comprising a torque convertor (113; 213; 313).

12. A method (1200) of controlling an electrical motor, comprising the steps of:
a) optionally providing (1201) a plurality of electrical conductor portions (A, B, C) for conducting a plurality of electrical currents (la, Ib, Ic), which together form a combined magnetic field, and providing a first sensor device (104, 204, 304, 1404, 1504) comprising a plurality of magnetic sensors (S1; S1,S2; S1,S2,S3);
x) optionally providing (1202) a second sensor device (106, 206, 306, 1506) communicatively connected to the first sensor device, the second sensor device being configured for determining an actual angular position (ϕrot) of the rotor;
b) measuring (1203) by the first sensor device, at least two magnetic field components (Bx, By) or at least two magnetic field differences (ΔBx, ΔBy) or at least two magnetic field gradients of the combined magnetic field generated by the currents (Ia,Ib,Ic) flowing through the electrical conductor portions (A, B, C), in one or more sensor locations (S1; S1,S2; S1,S2,S3);
y) optionally transforming (1204) by the first sensor device, the measured magnetic field components or magnetic field differences or magnetic field gradients, before determining an angle (ϕ) of the vector;
c) determining and/or outputting (1205), by the first or second sensor device, one or more of the following sets of signals:
i) an angular position of the rotor (ϕrot) and/or one or more magnetic field components (Bx, By), and/or one or more magnetic field differences (ΔBx, ΔBy), and/or one or more magnetic field gradients;
ii) two or more signals (la,lb,lc, Iα,Iβ,|I|) indicative of (e.g. proportional to) the electrical currents (la, Ib, Ic) flowing in said electrical conductor portions (A, B, C);
ii) one or more signals (Bx,By; |B|, ϕ) indicative of (e.g. proportional to) a first field vector (v1) of the combined magnetic field generated by the currents (la, Ib, Ic) flowing through the electrical conductor portions (A,B,C) and flowing through the motor coils, and/or one or more signals (dB/dt, dϕ/dt, Δϕ; Id,lq) derived therefrom, optionally taking into account the rotor position (ϕrot);

13. A method (1300) of controlling an electrical motor, comprising the steps of:
a) optionally providing (1201) a plurality of electrical conductor portions (A, B, C) for conducting a plurality of electrical currents (la, Ib, Ic), which together form a combined magnetic field, and providing a first sensor device (104, 204, 304, 1404, 1504) comprising a plurality of magnetic sensors (S1; S1,S2; S1,S2,S3);
x) optionally providing (1202) a second sensor device (106, 206, 306, 1506) communicatively connected to the first sensor device, the second sensor device being configured for determining an actual angular position (ϕrot) of the rotor;
b) measuring (1203) by the first sensor device, at least two magnetic field components (Bx, By) or at least two magnetic field differences (ΔBx, ΔBy) or at least two magnetic field gradients of the combined magnetic field generated by the currents (Ia,Ib,Ic) flowing through the electrical conductor portions (A, B, C), in one or more sensor locations (S1; S1,S2; S1,S2,S3);
y) optionally transforming (1204) by the first sensor device, the measured magnetic field components or magnetic field differences or magnetic field gradients, before determining an angle (ϕ) of the vector;
c) performing by the first or second sensor device at least one of the following:
c1) outputting (1306) one or more of the measured angular position (ϕrot) and/or measured or determined magnetic field components (Bx,By), magnetic field differences (ΔBx,ΔBy) magnetic field gradients;
c2) calculating and/or outputting (1307) two or more signals (la,lb,lc, Iα,Iβ,|I|) indicative of (e.g. proportional to) the electrical currents (la, Ib, Ic) flowing in said electrical conductor portions (A, B, C);
c3) calculating and/or outputting (1308) one or more signals (Bx,By; |B|,ϕ) indicative of (e.g. proportional to) a field vector (v1) of the combined magnetic field generated by the currents (Ia,Ib,Ic) flowing through the electrical conductor portions (A, B, C) and flowing through the motor coils, and/or one or more signals (dB/dt, dϕ/dt, Δϕ; Id,lq) derived therefrom, optionally taking into account the rotor position (ϕrot);
c4) calculating and/or outputting (1309) current values (Id, Iq) in a rotor reference frame, based on the measured magnetic field values and on the rotor position (ϕrot).

14. A sensor device (104; 204; 304; 1404; 1504) for use in a sensor system according to any of the claims 1 to 10,
the sensor device comprising a plurality of magnetic sensors configured for measuring characteristics of a combined magnetic field generated by a plurality of currents (Ia,Ib,Ic) flowing in a plurality of electrical conductor portions (A, B, C);
the sensor device being configured to measure at least two magnetic field components (Bx,By) or at least two magnetic field differences (ΔBx, ΔBy) or at least two magnetic field gradients of the combined magnetic field in one or more sensor locations;
the sensor device optionally being configured to receive a rotor position (ϕrot);
the sensor device being configured to determine and/or output at least one of the following sets of signals:
i) said angular position of the rotor (ϕrot) and/or one or more of said magnetic field components (Bx,By) and/or one or more of said magnetic field differences or gradients;
ii) two or more signals (la,lb,lc, Iα,Iβ) indicative of (e.g. proportional to) the plurality of electrical currents (la, Ib, Ic) flowing in said electrical conductor portions (A, B, C);
iii) one or more signals (Bx,By; |B|,ϕ) indicative of (e.g. proportional to) a first field vector (v1) of the combined magnetic field, and/or one or more signals (dB/dt, dϕ/dt, Δϕ; Id,lq) derived therefrom,
based on said at least two magnetic field components or said at least two magnetic field differences or said at least two magnetic field gradients, optionally taking into account the received motor position (ϕrot).

15. A sensor device (1506) for use in a sensor system according to any of the claims 1 to 10,
the sensor device (1506) being configured to determine a rotor position (ϕrot);
the sensor device (1506) being configured to receive at least two magnetic field components (Bx,By) or at least two magnetic field differences (ΔBx, ΔBy) from another sensor device (1504) that is arranged relative to a plurality of conductor portions (A,B,C);
the sensor device (1506) being configured to determine and/or output at least one of the following sets of signals:
i) said angular position of the rotor (ϕrot) and/or one or more of said magnetic field components (Bx,By) and/or one or more of said magnetic field differences or gradients;
ii) two or more signals (la,lb,lc, Iα,Iβ) indicative of (e.g. proportional to) the plurality of electrical currents (la, Ib, Ic) flowing in said electrical conductor portions (A, B, C);
iii) one or more signals (Bx,By; |B|,ϕ) indicative of (e.g. proportional to) a first field vector (v1) of the combined magnetic field, and/or one or more signals (dB/dt, dϕ/dt, Δϕ; Id,lq) derived therefrom,
based on said at least two magnetic field components or said at least two magnetic field differences or said at least two magnetic field gradients, optionally taking into account the received motor position (ϕrot).
